# EUROPEAN PATENT APPLICATION

(11) **EP 4 485 545 A1**
(43) Date of publication of application: **01.01.2025**
(21) Application number: 24182626.2
(22) Date of filing: 17.06.2024
(51) Int. Cl.: H01L 29/778, H01L 21/338, H01L 29/40, H01L 23/31, H01L 29/20

(54) **TRANSISTORS WITH RECESSED FIELD PLATES AND METHODS OF FABRICATION THEREOF**

(30) Priority: 29.06.2023 US 202318344363
(71) Applicant: NXP USA, Inc., Austin TX 78735 (US)
(72) Inventor: Zhu, Congyong, 5656AG Eindhoven (NL); Renaud, Philippe, 5656AG Eindhoven (NL); Hill, Darrell Glenn, 5656AG Eindhoven (NL); Hale, Gregory Daivd, 5656AG Eindhoven (NL); Rampley, Colby Greg, 5656AG Eindhoven (NL)
(74) Representative: Hardingham, Christopher Mark

(57) **Abstract**

A transistor device and method of fabrication are provided, where the transistor device may include a first dielectric layer (116) disposed on a surface of a semiconductor substrate (110), a second dielectric layer (118) disposed directly on the first dielectric layer, a third dielectric layer (148) disposed on the second dielectric layer, a gate structure (128) disposed directly on the surface of the semiconductor substrate in the gate channel, and a field plate (135) disposed overlapping the gate structure. The gate may be defined via an opening that extends through the first, second, and third dielectric layers. Portions of the first and second dielectric layers may be interposed directly between the gate structure and the surface of the semiconductor substrate. A portion of the field plate may be disposed in a field plate channel (154) at least partially defined via a second opening that extends through the second dielectric layer and the third dielectric layer.

## Description

### TECHNICAL FIELD

Embodiments of the subject matter described herein relate generally to transistor devices, and more particularly to semiconductor power transistors field plates.

### BACKGROUND

High-power field effect transistor (FET) devices find application in a wide variety of electronic components and systems. While various advances have been made to improve gain, efficiency, and other characteristics of power FETs that are used to provide amplification in radio frequency (RF) communication systems, challenges still exist for fabricating such devices. For example, fabricating FETs with short gate lengths using photolithography alone is more challenging for gallium nitride (GaN) on silicon carbide (SiC) based FETs than for silicon (Si) based FETs, due in part to transparency of SiC substrates and to lack of sufficiently uniform flatness of GaN-on-SiC substrates due to, for example, side effects of heteroepitaxy (used to grow GaN on SiC). As another example, dielectric layers exposed to multiple dry etch processes during device fabrication may experience plasma damage and etch-induced thickness variation, undesirably impacting performance and reliability.

### SUMMARY

A brief summary of various exemplary embodiments is presented below. Some simplifications and omissions may be made in the following summary, which is intended to highlight and introduce some aspects of the various exemplary embodiments, without limiting the scope. Detailed descriptions of an exemplary embodiment adequate to allow those of ordinary skill in the art to make and use these concepts will follow in later sections.

In an example embodiment, a transistor device includes a semiconductor substrate, a first dielectric layer disposed on a surface of the semiconductor substrate, a second dielectric layer disposed directly on the first dielectric layer, a third dielectric layer disposed on portions of the second dielectric layer, a gate structure, and a field plate. A gate channel is at least partially defined via a first opening that extends through the first dielectric layer, the second dielectric layer, and the third dielectric layer. The gate structure is disposed directly on the surface of the semiconductor substrate in the gate channel. Portions of the first dielectric layer and the second dielectric layer are interposed directly between portions of the gate structure and the surface of the semiconductor substrate. The field plate is disposed at least partially overlapping the gate structure. A portion of the field plate is disposed in a field plate channel that is at least partially defined via a second opening that extends through at least the second dielectric layer and the third dielectric layer.

In one or more embodiments, the transistor device further includes an interlayer dielectric layer disposed over the first dielectric layer, the second dielectric layer, the third dielectric layer, and the gate structure.

In one or more embodiments, the field plate at least partially overlaps the interlayer dielectric layer, such that the interlayer dielectric layer is interposed between the gate structure and the field plate.

In one or more embodiments, the transistor device further includes a fourth dielectric layer that is at least partially disposed directly on the surface of the semiconductor substrate in the field plate channel.

In one or more embodiments, portions of the fourth dielectric layer are disposed directly on surfaces of the interlayer dielectric layer, the first dielectric layer, the second dielectric layer, and the third dielectric layer.

In one or more embodiments, the field plate is disposed directly on the fourth dielectric layer.

In one or more embodiments, the fourth dielectric layer separates the field plate from the surface of the semiconductor substrate in the field plate channel.

In one or more embodiments, the first dielectric layer and the third dielectric layer each include first dielectric material, the second dielectric layer and the interlayer dielectric layer each include second dielectric material, and the second dielectric material has as a different etch rate from the first dielectric material with respect to at least one wet etch process.

In an example embodiment, a method of fabricating a transistor device includes providing a semiconductor substrate, forming a first dielectric layer on the semiconductor substrate, forming a second dielectric layer on the first dielectric layer, forming a gate channel and a field plate channel by performing a first patterned dry etch to form a first opening and a second opening in the second dielectric layer and performing a first wet etch to form a third opening and a fourth opening in the first dielectric layer, forming a third dielectric layer directly on the second dielectric layer and directly on surfaces of the semiconductor substrate exposed through the third opening and the fourth opening, removing a first portion of the third dielectric layer from the gate channel, forming a gate structure disposed at least partially in the gate channel and in contact with surfaces of the semiconductor substrate, the first dielectric layer, and the second dielectric layer, and forming a field plate overlapping the gate structure, wherein at least a portion of the field plate is disposed in the field plate channel.

In one or more embodiments, the method further includes forming a first patterned photoresist layer over the semiconductor substrate having a fifth opening overlapping the gate channel and forming a second patterned photoresist layer over the semiconductor substrate having a sixth opening overlapping the gate channel. Removing the first portion of the third dielectric layer from the gate channel includes, after forming the first patterned photoresist layer and the second patterned photoresist layer, performing a second wet etch to remove the first portion of the third dielectric layer.

In one or more embodiments, the method further includes forming an interlayer dielectric layer on the gate structure and the third dielectric layer, wherein the field plate is disposed over the interlayer dielectric layer.

In one or more embodiments, the method further includes performing a second patterned dry etch to form a seventh opening in the interlayer dielectric layer through which a portion of the third dielectric layer is exposed.

In one or more embodiments, the method further includes, before forming the field plate, performing a second wet etch to remove a second portion of the third dielectric layer that is exposed through the seventh opening, and, before forming the field plate, forming a fourth dielectric layer disposed on surfaces of the interlayer dielectric layer and, in the field plate channel, on the surface of the semiconductor substrate.

In one or more embodiments, the field plate is formed in direct contact with the fourth dielectric layer, and the fourth dielectric layer is directly interposed between the field plate and the surface of the semiconductor substrate in the field plate channel.

In an example embodiment, a method of fabricating a transistor device includes, providing a semiconductor substrate, forming a first dielectric layer on the semiconductor substrate, forming a second dielectric layer on the first dielectric layer, forming a gate channel and a field plate channel at least by performing a first patterned dry etch to form a first opening and a second opening in the second dielectric layer, forming a third dielectric layer directly on surfaces of the first dielectric layer and directly on surfaces of the second dielectric layer exposed through the first opening and the second opening, performing a first wet etch to remove a first portion of the first dielectric layer and a first portion of the third dielectric layer from the gate channel, exposing the surface of the semiconductor substrate in the gate channel, forming a gate structure disposed at least partially in the gate channel and in contact with surfaces of the semiconductor substrate, the first dielectric layer, and the second dielectric layer, and forming a field plate overlapping the gate structure, wherein at least a portion of the field plate is disposed in the field plate channel.

In one or more embodiments, the method further includes forming a first patterned photoresist layer over the semiconductor substrate having a third opening overlapping the gate channel, and forming a second patterned photoresist layer over the semiconductor substrate having a fourth opening overlapping the gate channel, wherein the first wet etch is performed after forming the second patterned photoresist layer.

In one or more embodiments, the method further includes forming an interlayer dielectric layer on the gate structure and the third dielectric layer, wherein the field plate is disposed over the interlayer dielectric layer.

In one or more embodiments, the method further includes performing a second patterned dry etch to form a fifth opening in the interlayer dielectric layer through which a portion of the third dielectric layer is exposed.

In one or more embodiments, the method further includes, before forming the field plate, performing a second wet etch to remove a second portion of the third dielectric layer that is exposed through the fifth opening, and, before forming the field plate, forming a fourth dielectric layer disposed on surfaces of the interlayer dielectric layer and, in the field plate channel, on the surface of the semiconductor substrate.

In one or more embodiments, the field plate is formed in direct contact with the fourth dielectric layer, and the fourth dielectric layer is directly interposed between the field plate and the surface of the semiconductor substrate in the field plate channel.

### BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures.
FIG. 1 is a cross-sectional side view of a transistor device, in accordance with various embodiments.
FIG. 2 is a process flow diagram describing a method for fabricating the transistor device of FIG. 1, in accordance with various embodiments.
FIGS. 3-17 are cross-sectional views depicting the transistor devices of FIG. 1 at various stages of fabrication in connection with the method of FIG. 2, in accordance with various embodiments.
FIG. 18 is a process flow diagram describing a method for fabricating the transistor device of FIG. 1, in accordance with various embodiments.
FIGS. 19-33 are cross-sectional views depicting the transistor device of FIG. 1 at various stages of fabrication in connection with the method of FIG. 18, in accordance with various embodiments.

### DETAILED DESCRIPTION

The following detailed description is merely illustrative in nature and is not intended to limit the embodiments of the subject matter or the application and uses of such embodiments. Furthermore, there is no intention to be bound by any expressed or implied theory presented in the preceding technical field, background, or the following detailed description.

For simplicity and clarity of illustration, the drawing figures illustrate the general manner of construction, and descriptions and details of well-known features and techniques may be omitted to avoid unnecessarily obscuring embodiments described herein. Additionally, elements in the drawing figures are not necessarily drawn to scale. For example, the dimensions of some of the elements or regions in the figures may be exaggerated relative to other elements or regions to help improve understanding of embodiments described herein.

The terms "first," "second," "third," "fourth" and the like in the description and the claims, if any, may be used for distinguishing between similar elements and not necessarily for describing a particular sequential or chronological order. It is to be understood that the terms so used are interchangeable under appropriate circumstances such that the embodiments described herein are, for example, capable of operation in sequences other than those illustrated or otherwise described herein. Furthermore, the terms "comprise," "include," "have" and any variations thereof, are intended to cover non-exclusive inclusions, such that a process, method, article, or apparatus that comprises a list of elements is not necessarily limited to those elements but may include other elements not expressly listed or inherent to such process, method, article, or apparatus. The term "coupled," as used herein, is defined as directly or indirectly connected in an electrical or non-electrical manner. As used herein the terms "substantial" and "substantially" mean sufficient to accomplish the stated purpose in a practical manner and that minor imperfections, if any, are not significant for the stated purpose. As used herein, the words "exemplary" and "example" mean "serving as an example, instance, or illustration." Any implementation described herein as exemplary or an example is not necessarily to be construed as preferred or advantageous over other implementations.

Directional references such as "top," "bottom," "left," "right," "above," "below," and so forth, unless otherwise stated, are not intended to require any preferred orientation and are made with reference to the orientation of the corresponding figure or figures for purposes of illustration.

For the sake of brevity, conventional semiconductor fabrication techniques may not be described in detail herein. In addition, certain terms may also be used herein for reference only, and thus are not intended to be limiting. For instance, the terms "first", "second", and other such numerical terms referring to structures do not imply a sequence or order unless clearly indicated by the context.

Various embodiments described herein relate to transistor devices and an associated fabrication methods in which one or more dielectric layers damaged by exposure to dry etching (e.g., due to plasma damage) are removed, replaced, or covered (at least in part) during the fabrication process. As will be described, the removal and replacement of dry-etch-damaged dielectric layers may result in advantageously reduce performance variation associated with such dielectric layers, may advantageously improve thickness uniformity of dielectric layers in the transistor device, and may advantageously reduce the incidence of charge carrier trapping at or near the surface of the semiconductor substrate in a field plate channel.

In one or more embodiments, when fabricating a transistor device, a first dielectric layer is formed on the surface of a semiconductor substrate and a second dielectric layer is formed on the first dielectric layer. A gate channel and a field plate channel are formed, at least in part, by first performing a patterned dry etch of the second dielectric layer during which the first dielectric layer acts as an etch stop to avoid damage to the surface of the semiconductor substrate. In one or more embodiments, portions of the first dielectric layer which are exposed (and may be damaged) during the dry etch are subsequently removed via a patterned or non-patterned wet etch. In one or more other embodiments, these portions of the first dielectric layer are instead removed via the same wet etch process used to remove the first and second portions of the third dielectric layer (described below).

In one or more embodiments, portions of the field plate channel and the gate channel are formed concurrently via the dry etch and wet etch used to remove portions of the second dielectric layer and portions of the first dielectric layer, respectively. The surface of the semiconductor substrate is exposed through the field plate channel. Then, a third dielectric layer is formed over the substrate, where first and second portions of the third dielectric layer are formed directly on the surface of the semiconductor substrate in the gate channel and the field plate channel, respectively, thereby protecting the surface of the semiconductor substrate during subsequent processing steps. The first portion of the third dielectric layer is removed via a wet etch (e.g., in conjunction with a photolithographic liftoff process associated with gate structure formation, as a non-limiting example). An electrically conductive gate structure is formed via deposition of gate metal in and around the gate channel after removal of a first portion of the third dielectric layer in the gate channel. After formation of the gate structure, an interlayer dielectric (ILD) layer is formed over the gate structure, the second dielectric layer, and on the portions of the third dielectric layer disposed in the field plate channel. A patterned dry etch is performed to form an opening in the ILD layer overlapping the field plate channel, with a second portion of the third dielectric layer disposed in the field plate channel acting as an etch stop for the patterned dry etch of the ILD layer.

In one or more embodiments, a wet etch is then performed to the second portion of the third dielectric layer disposed in the field plate channel and exposed through the opening in the ILD layer (these portions potentially having been damaged during the patterned dry etch of the ILD layer), thereby exposing the surface of the semiconductor substrate. A fourth dielectric layer is then formed over the ILD layer and on the surface of the semiconductor substrate exposed in the field plate channel. An electrically conductive field plate is then formed on the fourth dielectric layer, with at least a portion of the field plate being disposed in the field plate channel.

By using the fourth dielectric layer to line the field plate channel, rather than potentially damaged portions of the first and/or third dielectric layers, the thickness of material between the field plate and the semiconductor substrate can be more precisely controlled. Additionally, by removing potentially damaged portions of the first and third dielectric layers in the field plate channel, then depositing the fourth dielectric layer in the field plate channel, charge carrier trapping attributable to such damaged dielectric layers may be reduced or avoided, which may advantageously improve threshold voltage stability for the transistor device.

In one or more other embodiments, the portions of the third dielectric layer in the field plate channel are not removed, the fourth dielectric layer is not formed over the ILD layer, and the field plate is instead formed directly on portions of the ILD layer and on the second portion of the third dielectric layer disposed in the field plate channel. This may advantageously reduce exposure of the surface of the semiconductor substrate in the field plate channel, though with potential thickness uniformity impacts. In one or more such embodiments, if the first dielectric layer is not removed prior to formation of the third dielectric layer, exposure of the surface of the semiconductor substrate in the field plate channel may be further reduced.

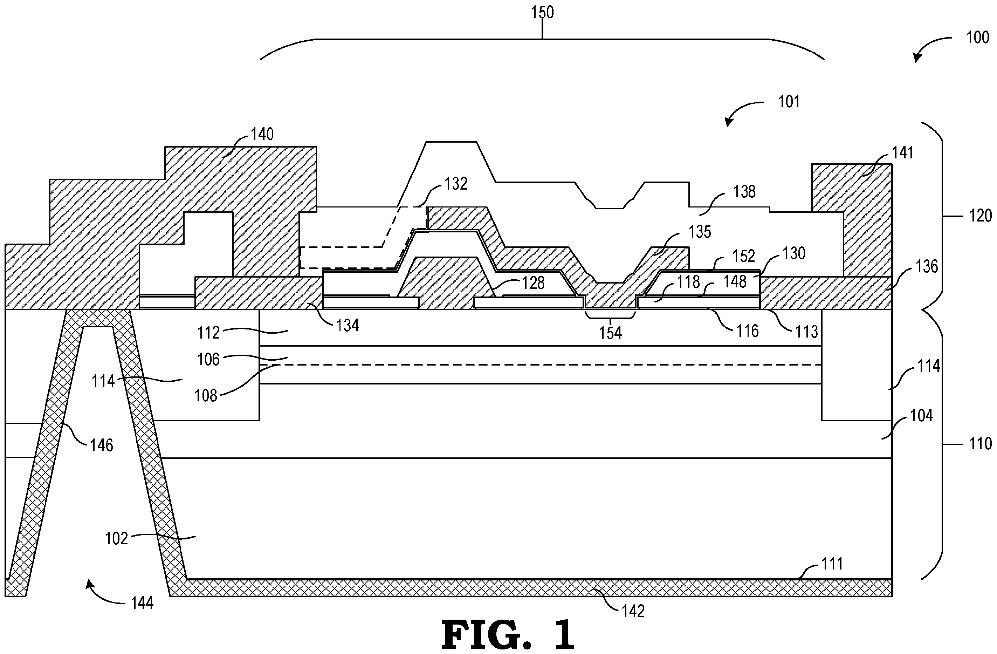

FIG. 1 is a cross sectional side view of a transistor device 100 in accordance with one or more embodiments. The transistor device 100 may be formed on a semiconductor die having a base semiconductor substrate 110 (sometimes referred to herein as the "substrate 110") and an overlying build-up structure 120. The substrate 110 is defined by an upper surface 113 and a lower surface 111, along with side walls that extend between the lower and upper substrate surfaces 111, 113. Multiple additional electrical structures, patterned conductive layers, and dielectric layers are included in the build-up structure 120, which is disposed in direct contact with and overlies the upper surface 113 of the substrate 110.

In one or more embodiments, an active region 150 is defined corresponding to a portion of the substrate 110 and an overlying portion of the build-up structure 120. One or more isolation regions 114 may be included within the substrate 110 at the upper surface 113. The active region 150 may include portions of the substrate 110 extending between at least two of the isolation regions 114.

In one or more embodiments, the semiconductor substrate 110 may include a host semiconductor substrate 102 (sometimes referred to herein as the "host substrate 102") and multiple layers overlying the host substrate 102. In one or more embodiments, the layers overlying the host substrate 102 may include a buffer layer 104, a channel layer 106, and a barrier layer 112, all of which are described in more detail, below.

In one or more embodiments, the build-up structure 120 is formed on and over the upper surface 113 of the substrate 110 and includes various electrical structures (e.g., a gate electrode 128, ohmic contact structures 134, 136), dielectric layers (e.g., dielectric layers 116, 118, 130, 138, 148, 152), and patterned conductive layers (e.g., a field plate 135, interconnect layers 140, 141).

In one or more embodiments, a backside metal layer 142 is formed on the lower surface 111 of the substrate 110. The backside metal layer 142 may be electrically connected to conductive material 146 (i.e., electrically conductive material) formed in a through substrate via (TSV) 144, which electrically connects the backside metal layer 142 to the interconnect layer 140 at the upper surface 113 of the substrate 110.

A transistor 101 is formed in the active region 150 of the transistor device 100. In one or more embodiments, the transistor 101 is a field effect transistor (FET), which includes a gate electrode 128 (sometimes referred to herein as the "control electrode 128" or "gate structure 128"), a first ohmic contact structure 134 (sometimes referred to as the "source electrode 134" or "current-carrying electrode" 134) proximate to but spaced apart from a first sidewall of the gate electrode 128, and a second ohmic contact structure 136 (sometimes referred to as the "drain electrode 136" or "current-carrying electrode 136") proximate to but spaced apart from a second sidewall of the gate electrode 128, each of which are disposed at the upper surface 113 of the substrate 110 and are formed in the build-up structure 120 overlying the substrate 110. In one or more embodiments, the transistor 101 is a high electron mobility transistor (HEMT). In one or more embodiments, the transistor 101 is a gallium nitride (GaN) HEMT. It should be understood that these are non-limiting examples, and that the transistor 101 may be another suitable type of transistor in accordance with one or more other embodiments.

The ohmic contact structures 134, 136 are formed at and over the upper surface 113 of the substrate 110. In one or more embodiments, respective interfaces between the ohmic contact structures 134, 136 and respective portions the substrate 110 correspond to non-rectifying low resistance junctions (i.e., "ohmic contacts") through which electrical current may be readily conducted between semiconductor material of the substrate 110 and conductive material of the ohmic contact structures 134, 136. For example, the ohmic contact structures 134, 136 may be formed substantially in-plane with respect to one another, and both of the source electrode 134 and the drain electrode 136 may extend through at least dielectric layers 116, 118 (sometimes referred to herein as the "first dielectric layer 116" and the "second dielectric layer 118", respectively) to directly contact the upper surface 113 of the substrate 110. Additionally, the ohmic contact structures 134, 136 may be respectively electrically coupled to opposite ends of a channel 108 that is disposed within the channel layer 106 of the substrate 110. The first ohmic contact structure 134 may be electrically coupled to the TSV 144 and the backside metal layer 142 through patterned portions of one or more of the interconnect metal layers (e.g., interconnect layer 140) of the build-up structure 120. The second ohmic contact structure 136 may be electrically coupled to an output (not shown) of the transistor device 100 via the interconnect layer 141, for example.

The gate electrode 128 may be a metallic structure that is electromagnetically coupled to the channel 108 in one or more embodiments. In one or more embodiments, the gate electrode 128 includes metallic material, such as gold, nickel, copper, tungsten, or any suitable combination of these, as non-limiting examples. In one or more other embodiments, the gate electrode 128 includes non-metallic material, such as suitably doped polysilicon as a non-limiting example. According to an embodiment, the gate electrode 128 extends through at least the first dielectric layer 116, the second dielectric layer 118, and the third dielectric layer 148 to contact the upper surface 113 of the substrate 110 between the ohmic contact structures 134, 136. An opening in the first and second dielectric layers 116, 118, through which portions of the gate electrode 128 are formed, is sometimes referred to as the "gate channel" herein. The region of the build-up structure 120 at which the gate electrode 128 is formed is sometimes referred to as the "gate channel region" herein. In one or more embodiments, the interface at which the gate electrode 128 makes contact with the substrate 110 is a Schottky contact.

In one or more embodiments, the build-up structure 120 includes the dielectric layers 116, 118, 148, disposed over the upper surface 113 of the substrate 110, an interlayer dielectric (ILD) layer 130 formed on portions of the gate electrode 128 and the dielectric layer 118, a dielectric layer 152 formed on portions of the ILD layer 130 and on the surface 113 in a field plate channel 154, a field plate 135 formed on portions fourth dielectric layer 152 (overlapping portions of the gate electrode 128) and in the field plate channel 154, and a dielectric layer 138 formed over portions of the field plate 135 and the ILD layer 130. The field plate channel 154 is at least partially defined by openings in the first and second dielectric layers 116, 118. As mentioned above, the gate electrode 128 may extend through openings in the dielectric layers 116, 118. Each of the gate electrode 128 and the ohmic contact structures 134, 136 contact the upper surface 113 of the substrate 110 at various points directly above the channel 108. In one or more embodiments, the first dielectric layer 116 may have a thickness in a range of around 30 Angstroms to around 1,500 Angstroms, and the second dielectric layer 118 may have a thickness in a range of around 100 to around 4,000 Angstroms, although other suitable thickness values may be used. Herein, a value is considered to be "about" or "approximately" equal to a stated number if it is within +/- 10% of that number, unless stated otherwise.

In one or more embodiments, the dielectric layers 116, 118, 148, 152 are formed from respective dielectric materials, such as aluminum oxide (Al₂O₃), silicon nitride (SiN; sometimes given as Si₃N₄), silicon oxide (SiO₂), silicon oxynitride (SiON), aluminum nitride (AlN), silicon aluminum nitride (SiAlN), hafnium oxide (HfO₂), zirconium oxide (ZrO₂), titanium oxide (TiO₂), or other suitable dielectric materials. In one or more embodiments, the first dielectric layer 116 and the third dielectric layer 148 may each be separately etchable with respect to the second dielectric layer 118 with respect to one or more etch processes (e.g., wet chemical etch processes, such as a buffered oxide etch (BOE) or a phosphoric acid etch, or dry etch processes, such as a reactive ion etch (RIE) or other suitable plasma etch processes, as non-limiting examples). For example, the first dielectric layer 116 and the third dielectric layer 148 may each be formed from the same first dielectric material (e.g., oxide material, such as aluminum oxide (AlOx)) and the second dielectric layer 118 may be formed from a second dielectric material (e.g., nitride material, such as silicon nitride (SiNx)) that is separately etchable with respect to the first dielectric material. In one or more other embodiments, the first dielectric layer 116 and the third dielectric layer 148 may be formed from respectively different dielectric materials (e.g., different oxide materials). For example, the first dielectric layer 116 may be formed from oxide (e.g., SiO₂, ZrO₂, HfO₂, Al₂O₃, or TiO₂ as non-limiting examples), the second dielectric layer 118 may be formed from nitride (e.g., SiN, AlN, SiAlN as non-limiting examples), and the third dielectric layer 148 may be formed from an oxide material (e.g., SiO₂, ZrO₂, HfO₂, Al₂O₃, or TiO₂ as non-limiting examples). Herein, two given materials are considered to be "separately etchable" with respect to a given etch process if the etch rate of a first material of the two materials is significantly greater (e.g., around 1.5 times as great or greater) than the etch rate of the second material of the two materials with respect to the given etch process.

In one or more embodiments, the dielectric layers 116, 118, 148, 152 are formed over the substrate 110 using respective chemical vapor deposition processes, such as low-pressure chemical vapor deposition (LPCVD), plasma enhanced chemical vapor deposition (PECVD), or atomic layer deposition (ALD). For example, in one or more embodiments, the first dielectric layer 116 and the third dielectric layer 148 may each be AlOₓ formed using an ALD process. In one or more embodiments, the second dielectric layer 118 may be SiNx formed using a PECVD process.

The field plate 135 may be formed from portions of a first conductive layer that overlaps at least portions of the gate electrode 128, the dielectric layers 116, 118, 148, and the ILD layer 130. The field plate 135 may be at least partially disposed in the field plate channel 154, where the field plate 135 is separated from the surface 113 of the substrate 110 in the field plate channel 154 by the fourth dielectric layer 152. At various points above the channel 108 (along a dimension extending directly into the plane of FIG. 1, straps of conductive material (not shown in the presently illustrated cross-section) are formed in a region 132 to electrically connect the field plate 135 to the interconnect layer 140. At other points above the channel 108, dielectric material from the dielectric layer 138 may instead be formed in the region 132, as shown in the example of FIG. 1. The straps of conductive material formed in the region 132 (in conjunction with the interconnect layer 140) electrically couple the field plate 135 to the source electrode 134 and the conductive material 146 of the TSV 144 (e.g., electrically coupling the field plate 135 to a ground or reference potential for instances in which the backside metal 142 is coupled to or otherwise configured to provide an electrical ground or reference potential).

The field plate 135 may be formed from one or more electrically conductive materials, such as titanium tungsten (TiW), titanium tungsten nitride (TiWN), tungsten silicide (WSi), as non-limiting examples. In one or more embodiments, at least some portions of the field plate 135 overlie the gate electrode 128, and thus are proximate to one or more side walls and the upper surface of the gate electrode 128, with portions of the ILD layer 130 and the fourth dielectric layer 152 being disposed directly between the field plate 135 and the gate electrode 128.

The fourth dielectric layer 152 may be formed after formation of the field plate channel 154 and prior to formation of the field plate 135. Separating the field plate 135 from the surface 113 of the substrate 110 using a dielectric layer that is formed after formation of the field plate channel 154 (i.e., using the fourth dielectric layer 152) ensures that this dielectric material has not been damaged by the etch (e.g., dry etch) used to form an opening in the ILD layer 130 that overlaps the field plate channel 154. Removal and replacement of damaged dielectric material in the field plate channel 154 reduces the likelihood of charge carrier traps being present in the field plate channel 154, which advantageously improves performance of the transistor device 100, including reducing threshold voltage instability for the transistor device 100. This approach also provides better thickness uniformity of the dielectric material that separates the field plate 135 from the surface 113 in the field plate channel 154, which advantageously reduces process variation with respect to the amount of separation between the field plate 135 and the surface 113 in the field plate channel 154.

The arrangement shown the present example is intended to be illustrative and not limiting. For example, in one or more other embodiments, the fourth dielectric layer 152 may be omitted, and the third dielectric layer 148 (alone or in combination with the first dielectric layer 116, in accordance with various embodiments) may instead cover the surface 113 of the substrate 110 in the field plate channel 154. In such embodiments, exposure of the surface 113 of the substrate 110 may be advantageously reduced, at least because the third dielectric layer 148 is not removed to expose the surface 113 of the substrate 110 after forming the opening in the ILD layer 130.

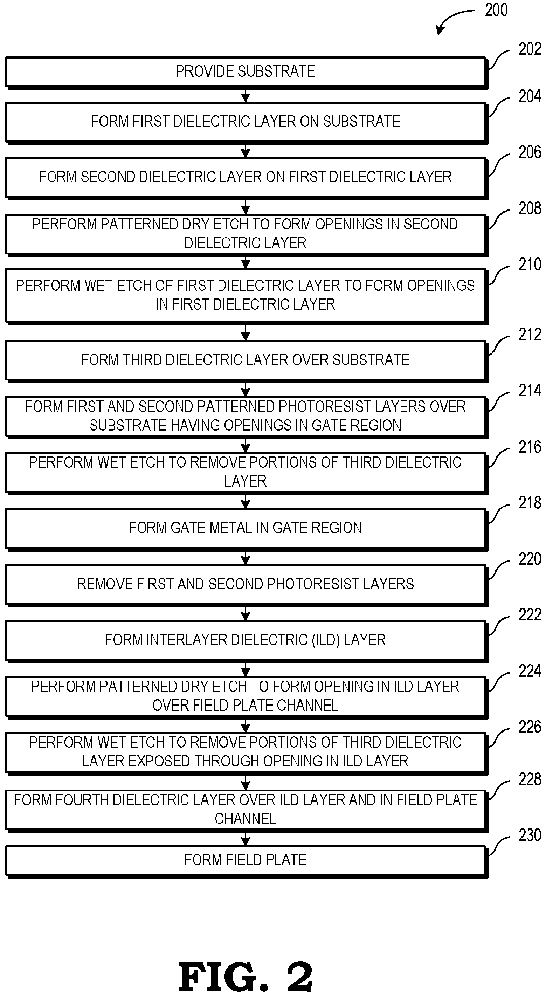

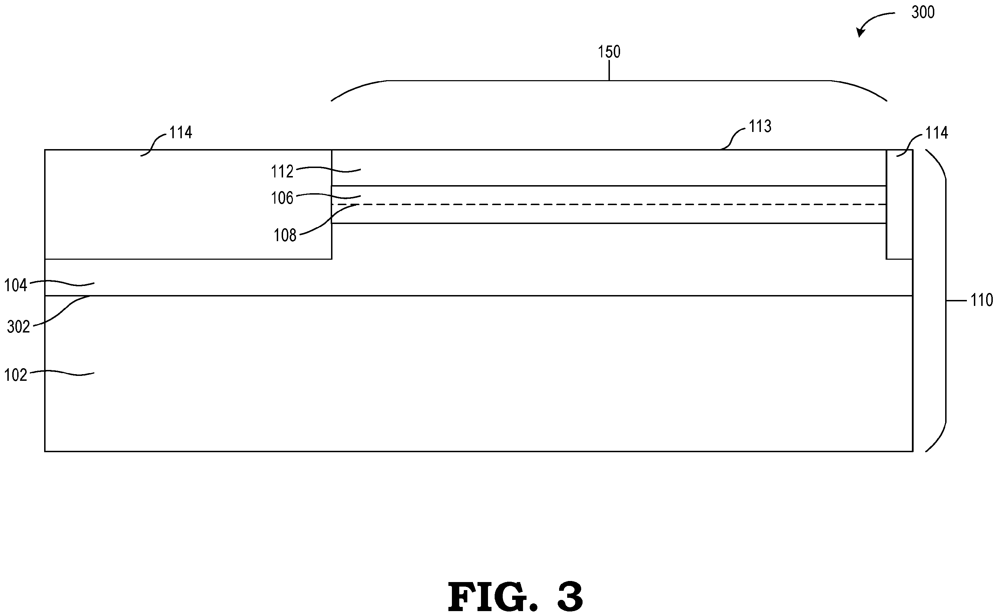

FIG. 2 is a process flow diagram depicting a method for fabricating at least a portion of a transistor device, such as the transistor device 100 of FIG. 1, in accordance with various embodiments. For enhanced understanding, FIG. 2 may be viewed simultaneously with FIGS. 3-17, which are cross sectional views depicting one or more embodiments of the transistor device 100 of FIG. 1 at various stages of fabrication.

Referring first to step 202 of FIG. 2 and to FIG. 3, at a first stage of fabrication 300, a semiconductor substrate 110 is provided, and an active region 150 is defined in the semiconductor substrate 110. As mentioned previously, the semiconductor substrate 110 may include a host semiconductor substrate 102 (sometimes referred to as the "host substrate 102") and multiple layers overlying the host substrate 102. In one or more embodiments, the layers overlying the host substrate 102 include a buffer layer 104, a channel layer 106, and a barrier layer 112.

In one or more embodiments, the host substrate 102 includes an upper surface 302 and may be formed from silicon carbide (SiC). In one or more other embodiments, the host substrate 102 may include other materials such as sapphire, silicon (Si), gallium nitride (GaN), aluminum nitride (AlN), diamond, boron nitride (BN), poly-SiC, silicon on insulator, gallium arsenide (GaAs), indium phosphide (InP), and other substantially insulating or high resistivity materials.

The buffer layer 104 may be formed on the upper surface 302 of host substrate 102. The buffer layer 104 may include one or more group III-nitride semiconductor layers. In one or more embodiments, the buffer layer 104 includes multiple layers of semiconductor material, where each of the layers of buffer layer 104 may include an epitaxially grown group-III nitride layer, for example. In such embodiments, the epitaxially grown group-III nitride layers of the buffer layer 104 may include nitrogen (N)-polar (i.e., N-face) or gallium (Ga)-polar (i.e., Ga-face) material, for example. In one or more other embodiments, the semiconductor layer(s) of the buffer layer 104 may not be epitaxially grown. In still other embodiments, the semiconductor layer(s) of the buffer layer 104 may include Si, GaAs, InP, or other suitable materials.

In one or more embodiments, the buffer layer 104 may include at least one AlGaN mixed crystal layer having a composition denoted by AlxGai-xN with an aluminum mole fraction, X, that can take on values between 0 and 1. The total thickness of buffer layer 104, including all of its constituent layers, may be between about 100 Angstroms and about 100,000 Angstroms although other thicknesses may be used. A limiting X value of 0 yields pure GaN while a value of 1 yields pure aluminum nitride (AlN). In one or more embodiments, the buffer layer 104 may include a nucleation region comprised of AlN. The nucleation region starts at the interface between the host substrate 102 and buffer layer 104 and may extend about 100 Angstroms to about 1,000 Angstroms into buffer layer 104. The buffer layer 104 may include additional AlxGai-xN layers formed over the nucleation region. The thickness of the additional AlxGai-xN layer(s) may be between about 100 Angstroms and about 50,000 Angstroms though other thicknesses may be used. In one or more embodiments, the additional AlxGai-xN layer(s) may be configured as GaN layer(s) (X=0) where the AlxGai-xN layer(s) are not intentionally doped (NID). Alternatively, the additional AlxGai-xN layer(s) may be configured as one or more GaN layers where the one or more GaN layers are intentionally doped with dopants that may include iron (Fe), chromium (Cr), carbon (C) or other suitable dopants that render buffer layer 104 substantially insulating or highly resistive. The dopant concentration may be between about 10¹⁷ cm⁻³ and 10¹⁹ cm⁻³ though other higher or lower concentrations may be used. The additional AlxGai-xN layers may be configured with X=0.01 to 0.10 where the AlxGaixN is NID or, alternatively, where the AlxGai-xN is intentionally doped with Fe, Cr, C, a combination of these, or other suitable dopant species. In one or more other embodiments, the additional AlxGai-xN layers may be configured as a superlattice where the additional Al_{X}Ga_{1-X}N layers include a series of alternating NID or doped AlxGai-xN layers where the value of X takes a value between 0 and 1. In still other embodiments, buffer layer 104 may include one or more indium gallium nitride (InGaN) layers, with composition denoted In_{Y}Ga_{1-Y}N, where Y, the indium mole fraction, may take a value between 0 and 1. The thickness of the InGaN layer(s) may be between about 10 Angstroms and about 1,000 Angstroms though other thicknesses may be used.

In one or more embodiments, the channel layer 106 may be formed over buffer layer 104. The channel layer 106 may include one or more group III-nitride semiconductor layers. The channel layer 106 may include an Al_{X}Ga_{1-X}N layer where X takes on values between 0 and 1. In one or more embodiments, the channel layer 106 is configured as GaN (X=0) although other values of X may be used. The thickness of the channel layer 106 may be between about 50 Angstroms and about 10,000 Angstroms, though other thicknesses may be used. The channel layer 106 may be NID or, alternatively, may include Si, Ge, C, Fe, Cr, or other suitable dopants. The dopant concentration may be between about 10¹⁶ and about 10¹⁹ cm⁻³ though other higher or lower concentrations may be used. In other embodiments, channel layer 106 may include NID or doped In_{Y}Ga_{1-Y}N, where Y, the indium mole fraction, may take a value between 0 and 1.

The barrier layer 112 may be formed over the channel layer 106, in accordance with one or more embodiments. The barrier layer 112 may include one or more group III-N semiconductor layers. The barrier layer 112 may have a larger bandgap and/or larger spontaneous polarization than the channel layer 106 and, when the barrier layer 112 is over channel layer 106, the channel 108 may be created in the form of a two-dimensional electron gas (2-DEG) within channel layer 106 adjacent the interface between the channel layer 106 and the barrier layer 112. In addition, tensile strain between the barrier layer 112 and channel layer 106 may cause additional piezoelectric charge to be introduced into the 2-DEG and the channel 108. The barrier layer 112 may include a multi-layer structure, where the first layer of the barrier layer 112 may include at least one NID AlxGai-xN layer where X takes on values between 0 and 1. In one or more embodiments, X may take a value of 0.1 to 0.35, although other values of X may be used. The thickness of the first layer of the barrier layer 112 may be between about 50 Angstroms and about 1,000 Angstroms though other thicknesses may be used. The barrier layer 112 may be NID or, alternatively, may include Si, Ge, C, Fe, Cr, or other suitable dopants. The dopant concentration may be between about 10¹⁶ and 10¹⁹ cm⁻³ though other higher or lower concentrations may be used.

An additional AlN interbarrier layer (not shown) may be formed between the channel layer 106 and the barrier layer 112, in one or more embodiments. The AlN interbarrier layer may introduce additional spontaneous and piezoelectric polarization, increasing the channel charge and improving the electron confinement of the resultant 2-DEG that forms the channel 108.

In other embodiments, the barrier layer 112 may include one or more indium aluminum nitride (InAlN) layers, denoted In_{Y}Al_{1-Y}N, where Y, the indium mole fraction, may take a value between about 0.1 and about 0.2 though other values of Y may be used. In the case of using InAIN to form the barrier layer 112, the thickness of the barrier layer 112 may be between about 50 Angstroms and about 1,000 Angstroms though other thicknesses may be used. In the case of using InAlN to form the barrier layer 112, the InAlN may be NID or, alternatively, may include Si, Ge, C, Fe, Cr, or other suitable dopants. The dopant concentration may be between about 10¹⁶ cm⁻³ and about 10¹⁹ cm⁻³ though other higher or lower concentrations may be used.

In one or more embodiments, a cap layer (not shown) may be formed over the barrier layer 112. When included, the cap layer presents a stable surface for the substrate 110 and serves to protect the upper surface 113 of the substrate 110 from chemical and environmental exposure incidental to wafer processing. The cap layer may include one or more group III-N semiconductor layers and is supported by the barrier layer 112. In one or more embodiments, the cap layer includes GaN. The thickness of the cap layer may be between about 5 Angstroms and about 100 Angstroms though other thicknesses may be used. The cap layer may be NID or, alternatively, may include Si, Ge, C, Fe, Cr, or other suitable dopants. The dopant concentration may be between about 10¹⁶ cm⁻³ and 10¹⁹ cm⁻³ though other higher or lower concentrations may be used.

The isolation regions 114 may be formed via an implantation procedure configured to damage the epitaxial and/or other semiconductor layers to create high resistivity regions of the substrate 110, rendering the substrate 110 high resistivity or semi-insulating in the high resistivity regions while leaving the crystal structure intact in the active region 150. In other embodiments (not shown), one or more of the isolation regions 114 may be formed by removing portions of one or more of the epitaxial and/or other semiconductor layers of the substrate 110 and leaving behind active region "mesas", such as the active region 150, surrounded by the isolation regions 114 (i.e., surrounded by regions of high resistivity or semi-insulating material). The transistor 101 of FIG. 1 may subsequently be formed within the active region 150.

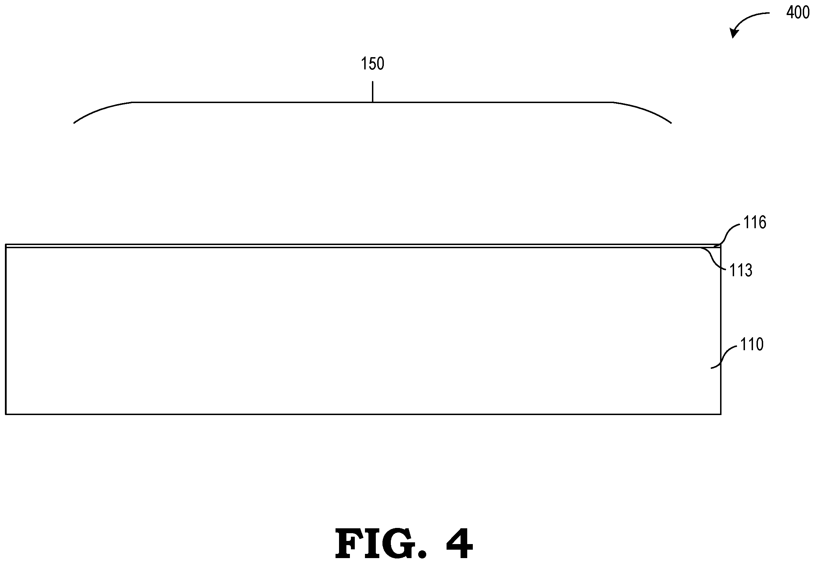

Referring next to step 204 of FIG. 2 and to FIG. 4, during a stage of fabrication 400, a first dielectric layer 116 is formed on (e.g., directly on and in contact with) the upper surface 113 of the semiconductor substrate 110. As mentioned above, in one or more embodiments, the first dielectric layer 116 may have a thickness in a range of about 30 Angstroms to about 1,500 Angstroms. The first dielectric layer 116 may be formed from dielectric material, such as Al₂O₃, SiN, Si₃N₄, SiO₂, SiON, AlN, SiAlN, HfO₂, ZrO₂, TiO₂, or another suitable material, which may be deposited via chemical vapor deposition (e.g., LPCVD) as a non-limiting example. In one or more embodiments, the first dielectric layer 116 may include an oxide (e.g., SiO₂, ZrO₂, HfO₂, Al₂O₃, or TiO₂ as non-limiting examples).

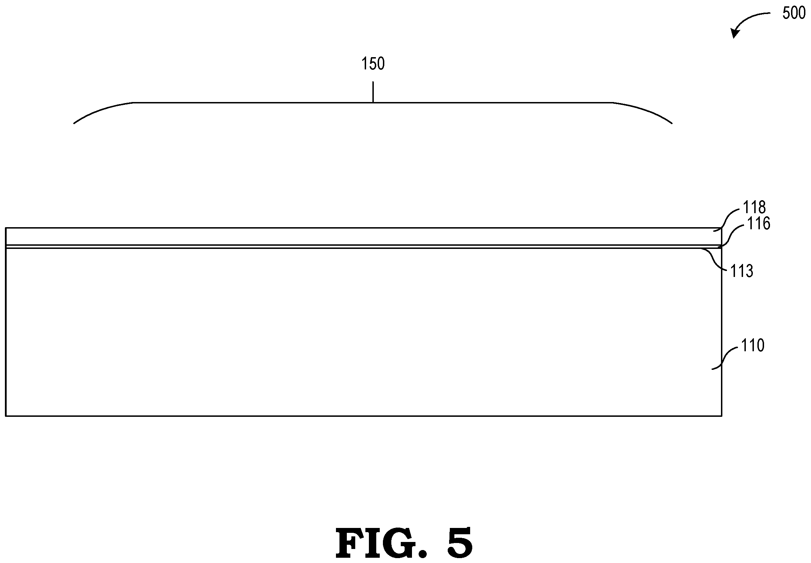

Referring next to step 206 of FIG. 2 and to FIG. 5, during a stage of fabrication 500, a second dielectric layer 118 is formed on (e.g., directly on and in contact with) the first dielectric layer 116. As mentioned above, in one or more embodiments, the second dielectric layer 118 may have a thickness in a range of about 100 Angstroms to about 4,000 Angstroms. The second dielectric layer 118 may be formed from dielectric material, such as Al₂O₃, SiN, Si₃N₄, SiO₂, SiON, AlN, SiAlN, HfO₂, ZrO₂, TiO₂, or another suitable material, which may be deposited via plasma enhanced chemical vapor deposition (e.g., PECVD) as a non-limiting example. In one or more embodiments, the second dielectric layer 118 may include a nitride (e.g., SiN, AlN, SiAlN as non-limiting examples).

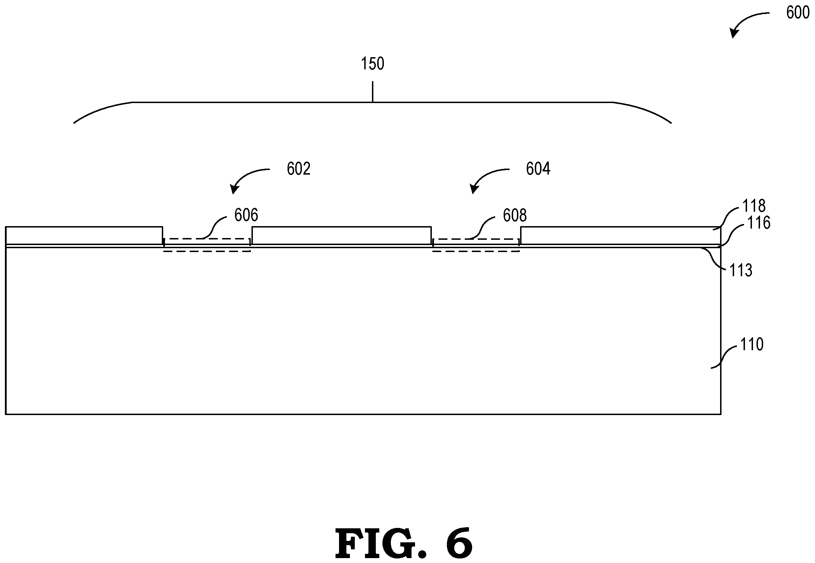

Referring next to step 208 of FIG. 2 and to FIG. 6, during a stage of fabrication 600, a patterned dry etch is performed to form openings 602, 604 in the second dielectric layer 118. Herein, a "patterned etch process" refers to a process in which etching of material is performed in conjunction with a photolithographic process, such that the material is etched through openings in a patterned photoresist layer.

For example, during the stage of fabrication 600, a dry etch process (e.g., a RIE process or other plasma etching process, as non-limiting examples) is performed in combination with a photolithographic process to remove portions of the second dielectric layer 118, forming the openings 602, 604 in the second dielectric layer 118, through each of which surfaces of the first dielectric layer 116 are exposed. The first dielectric layer 116 may act as an etch stop for this dry etch process, thereby mitigating or preventing damage to the surface 113 of the substrate 110. This results in the exposed portions 606, 608 of the first dielectric layer 116 potentially being damaged (e.g., due to plasma damage) by the dry etch process.

Additionally, some material of the exposed portion 608 of the first dielectric layer 116 is removed during the dry etch process, and the amount of material removed in this way can be process dependent and may not be uniform across concurrently fabricated transistor devices (e.g., when processing a wafer that includes multiple transistor devices). This can result in uncertainty as to the thickness of the exposed portion 608 and non-uniformity of the exposed portion 608.

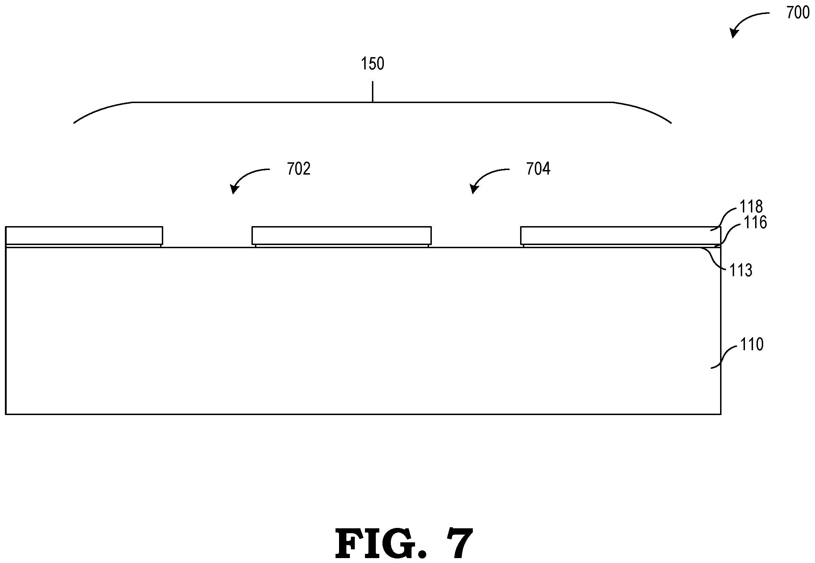

Referring next to step 210 of FIG. 2 and to FIG. 7, during a stage of fabrication 700, a wet etch is performed to remove the portions 606, 608 of the first dielectric layer 116 that were potentially damaged via exposure to the etch process at step 208. The wet etch forms openings 702, 704 that each extend through the first dielectric layer 116 and the second dielectric layer 118. In one or more embodiments, the wet etch is a patterned wet etch. In one or more other embodiments, the wet etch is performed without using a photolithographic process, and instead forms the openings 702, 704 using the existing pattern resulting from the dry etch process performed at step 208.

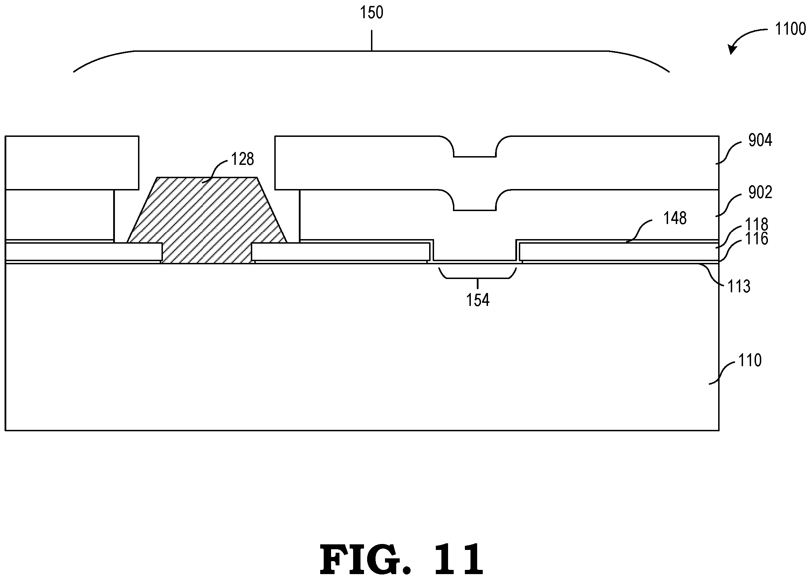

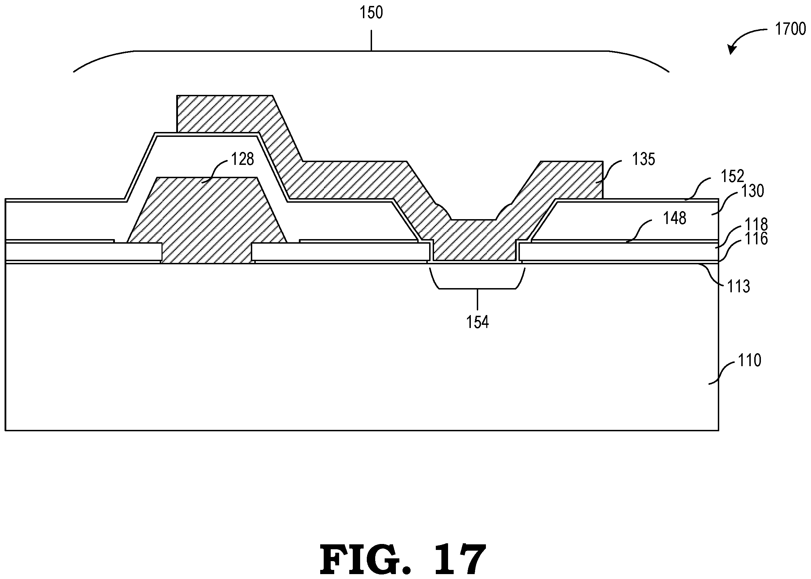

In one or more embodiments, the portions 606, 608 of the first dielectric layer 116 are removed via an anisotropic wet etch process that selectively etches the dielectric material (e.g., oxide material) of the first dielectric layer 116 with a higher etch rate than the dielectric material (e.g., nitride material) of the second dielectric layer 118. As shown, the wet etch may partially undercut the second dielectric layer 118 in the region of the openings 702, 704. The opening 702 may define at least a portion of the gate channel in which the gate structure is at least partially formed at a subsequent stage of fabrication (e.g., the stage of fabrication 1100 of FIG. 11). The opening 704 may define at least a portion of the field plate channel 154 in which the field plate 135 is at least partially formed at a subsequent stage of fabrication (e.g., the stage of fabrication 1700 of FIG. 17). Herein, a "wet etch" typically refers to a wet chemical etch unless indicated otherwise.

Removing the portion 608 of the first dielectric layer 116 in this way avoids having the portion 608 act as a charge carrier trapping center in the transistor 101 due to any damage the portion 608 may have received from the dry etch at the step 208. Removing the portion 608 of the first dielectric layer 116 also avoids or reduces thickness non-uniformity in the first dielectric layer 116 that would otherwise be attributable to the partial etching of the portion 608 during the dry etch at the step 208. Additionally, in conventional approaches, exposed portions of the first dielectric layer would need to be sufficiently thick to act as an etch stop for multiple etch processes. In contrast, in the present embodiment(s) the exposed portions 606, 608 of the first dielectric layer 116 only act as an etch stop once prior to being removed, which allows a comparatively thinner first dielectric layer 116 to be used. By using a thinner first dielectric layer 116, the amount of undercut that occurs when wet etching to remove the portions 606, 608, may be advantageously reduced.

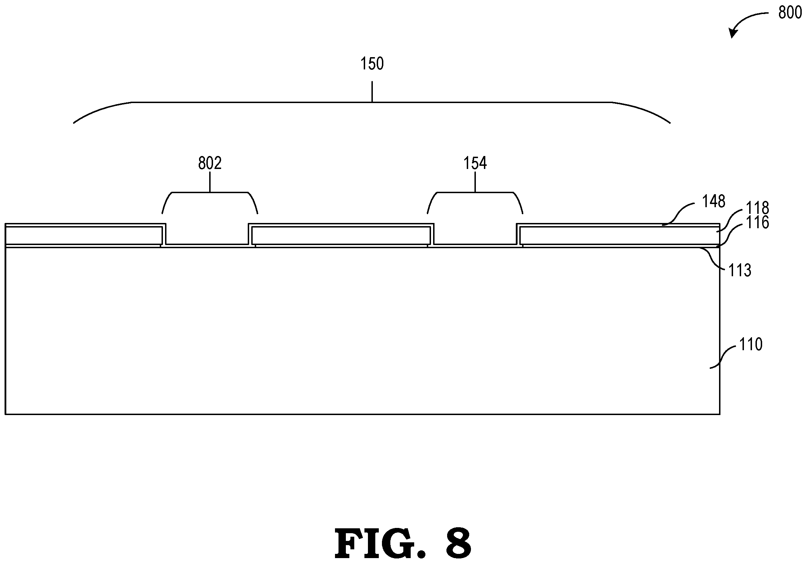

Referring next to step 212 of FIG. 2 and to FIG. 8, during a stage of fabrication 800, a third dielectric layer 148 is formed over the substrate 110. The third dielectric layer 148 may be formed directly on top and side surfaces of the second dielectric layer 118, side surfaces of the first dielectric layer 116, and the surface 113 of the substrate 110 exposed through the openings 702, 704 in the gate channel 802 and the field plate channel 154. In one or more embodiments, the third dielectric layer 148 may be formed from dielectric material, such as Al₂O₃, SiN, Si₃N₄, SiO₂, SiON, AlN, SiAlN, HfO₂, ZrO₂, TiO₂, or another suitable material, which may be deposited via chemical vapor deposition (e.g., LPCVD) as a non-limiting example. In one or more embodiments, the third dielectric layer 148 may include an oxide (e.g., SiO₂, ZrO₂, HfO₂, Al₂O₃, or TiO₂ as non-limiting examples).

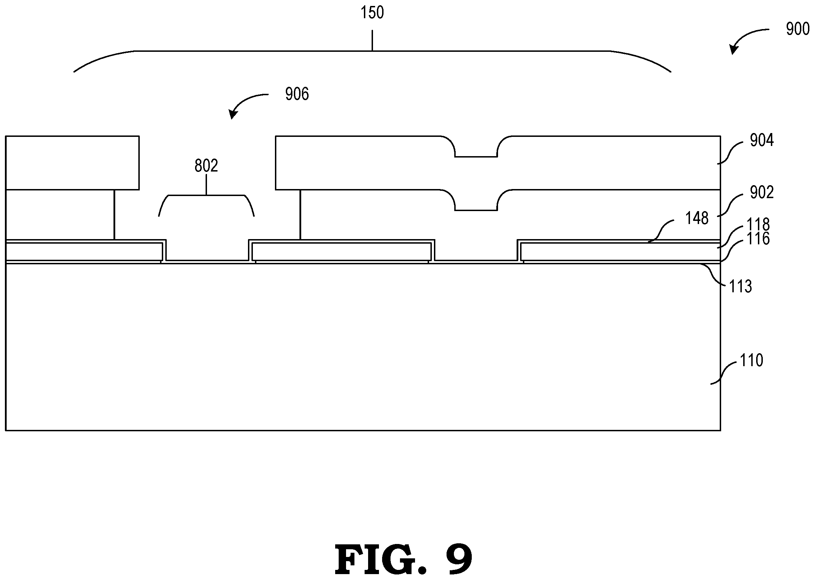

Referring next to step 214 of FIG. 2 and to FIG. 9, during a stage of fabrication 900, a first patterned photoresist layer 902 and a second patterned photoresist layer 904 are formed over the substrate 110. For example, the first patterned photoresist layer 902 and the second patterned photoresist layer 904 may be formed via respective photolithographic processes, each including spin coating photoresist material (e.g., resin) over the substrate 110, exposing the photoresist material to ultraviolet (UV) light through a patterned mask, and baking at a predetermined temperature, and removing portions of the photoresist material (e.g., removing those portions exposed to UV light when using positive photoresist material or removing those portions not exposed to UV light when using negative photoresist material) using a developer solution. An opening 906 is formed through the first and second photoresist layers 902, 904 through which a region (i.e., the "gate channel region") including the gate channel 802 is exposed.

In one or more embodiments, the first photoresist layer 902 may be developed concurrently with the second photoresist layer 904. As shown, the opening in the first photoresist layer 902 may be wider than the opening in the second photoresist layer 904, such that the second photoresist layer 904 overhangs the first photoresist layer 902 in the region of the opening 906.

In an example embodiment, the first photoresist layer 902 has a thickness of around 0.5 µm to around 2 µm, although it should be understood that other suitable thicknesses may be used. In an example embodiment, the second photoresist layer 904 has a thickness of between around 0.25 µm to around 1.5 µm although other suitable thicknesses may be used.

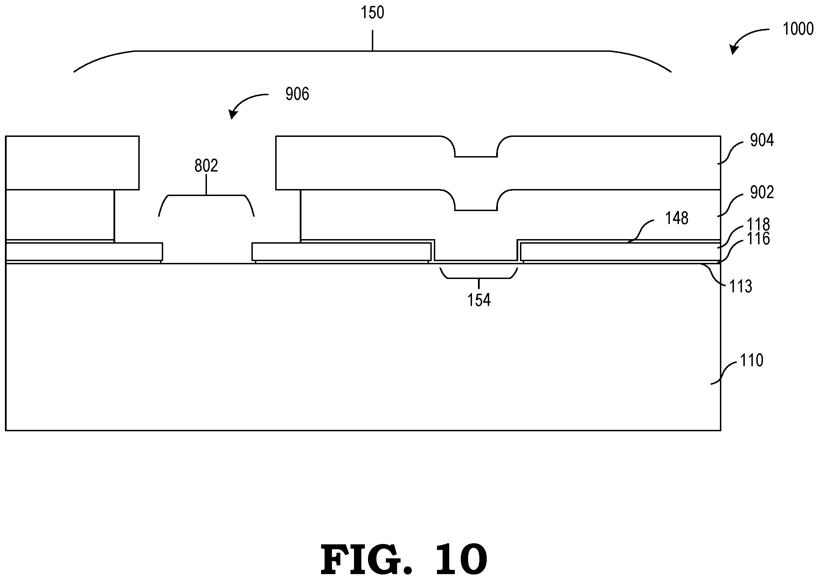

Referring next to step 216 of FIG. 2 and to FIG. 10, during a stage of fabrication 1000, a wet etch is performed to remove exposed portions of the third dielectric layer 148. For example, portions of the third dielectric layer 148 exposed through the opening 906 are removed via this wet etch process. Some portions of the third dielectric layer 148 remain upon completion of this wet etch process, which are disposed beneath the photoresist layer 902.

Referring next to step 218 of FIG. 2 and to FIG. 11, during a stage of fabrication 1100, a gate structure 128 is formed through the openings 906 in the first photoresist layer 902 and the second photoresist layer 904. The gate structure 128 may be electromagnetically coupled to the channel 108 through the upper surface 113 of the substrate 110 and the barrier layer 112. During operation of the transistor device 100, changes to the electric potential of gate structure 128 may shift the quasi-Fermi level for the barrier layer 112 compared to the quasi-Fermi level for the channel layer 106 and thereby modulate the electron concentration in the channel 108 within the portion of the substrate 110 under the gate structure 128.

In one or more embodiments, the gate structure 128 may be configured as a Schottky gate and may be formed over and directly in contact with the upper substrate surface 113 using a Schottky material layer and a conductive metal layer. In one or more embodiments, Schottky or other suitable materials may be combined with highly conductive materials in a metal stack to form the gate structure 128. For example, a Schottky material layer may first be formed in contact with the substrate 110, and a conductive low-stress metal may be deposited over the Schottky material layer to form the gate structure 128. In one or more other embodiments, the gate structure 128 may be formed over a gate dielectric or gate oxide (not illustrated) on the upper surface 113 of the substrate 110, thus forming a metal-insulator-semiconductor (MIS) junction or metal oxide semiconductor (MOS) junction, which may be electrically coupled to the channel 108 through the gate dielectric or gate oxide layer.

The gate structure 128 may have a T-shaped cross section, as shown in the present example, with a vertical stem over the substrate 110 that passes through at least the first dielectric layer 116 and the second dielectric layer 118 in the gate channel 802, and a wider portion over the vertical stem that has horizontal portions that overlie and contact upper surfaces of the second dielectric layer 118, in accordance with one or more embodiments. In one or more other embodiments (not shown), the gate structure 128 may have a square or rounded cross-sectional shape. In one or more other embodiments, the vertical stem or lower portion of the gate structure 128 may be recessed through the upper surface 113 of the semiconductor substrate 110 and may extend partially into the barrier layer 112, increasing the electrical coupling of gate structure 128 to channel 108 through the barrier layer 112.

The gate metal of the gate structure 128 may be deposited by evaporation, sputtering, chemical vapor deposition, or another suitable process. For example, a first portion of the deposited gate metal may be disposed in the opening 906 to form at least a portion of the gate structure 128 and a second portion of the deposited gate metal may be disposed on the upper surface(s) of the second photoresist layer 904.

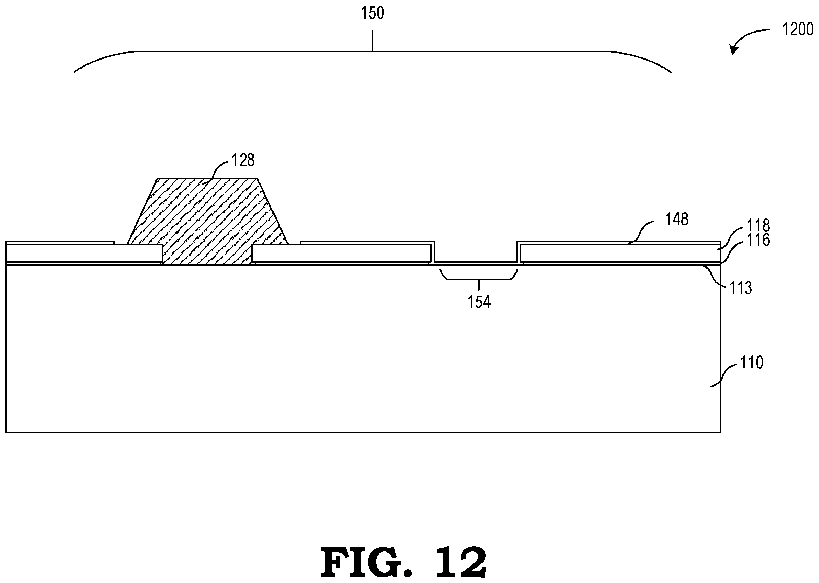

Referring next to step 220 of FIG. 2 and to FIG. 12, at a stage of fabrication 1200, the first photoresist layer 902, the second photoresist layer 904, and the second portion of gate metal deposited on the surface(s) of the second photoresist layer 904 are concurrently removed via a lift-off process. For example, in the lift-off process, a photoresist striper (e.g., a solvent such as acetone, 1-methyl-2-pyrrolidone, or dimethyl sulfoxide) may be applied to remove the first photoresist layer 902 and the second photoresist layer 904, which detaches (i.e., "lifts-off") the excess gate metal on the surface of the second photoresist layer 904.

While a bi-layer lift-off process has been described in connection with steps 214, 216, 218, 220 of FIG. 2 and stages of fabrication 900, 1000, 1100, 1200 of FIGS. 9-12, it should be understood that this is intended to be illustrative and not limiting. For example, other photolithographic processes (e.g., using a single photoresist layer that is developed with an undercut profile) may instead be used when forming the gate structure 128 in one or more other embodiments.

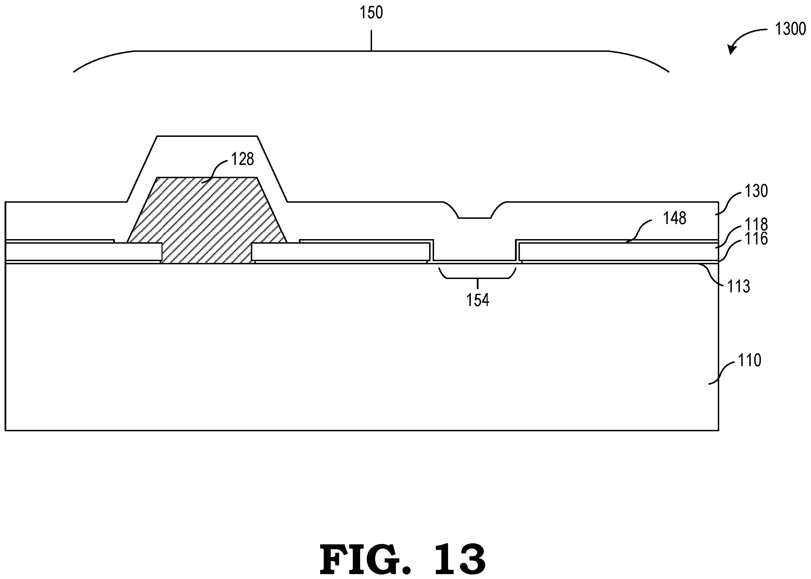

Referring next to step 222 of FIG. 2 and to FIG. 13, at a stage of fabrication 1300, an ILD layer 130 is formed over the substrate 110 (e.g., in contact with surfaces of each of the second dielectric layer 118 and the gate structure 128). In one or more embodiments, the ILD layer 130 has a thickness in a range of about 500 Angstroms to about 10,000 Angstroms, although other suitable thicknesses may be used. The ILD layer 130 may be formed from silicon nitride, silicon oxide, silicon oxynitride or other suitable dielectric materials, as non-limiting examples.

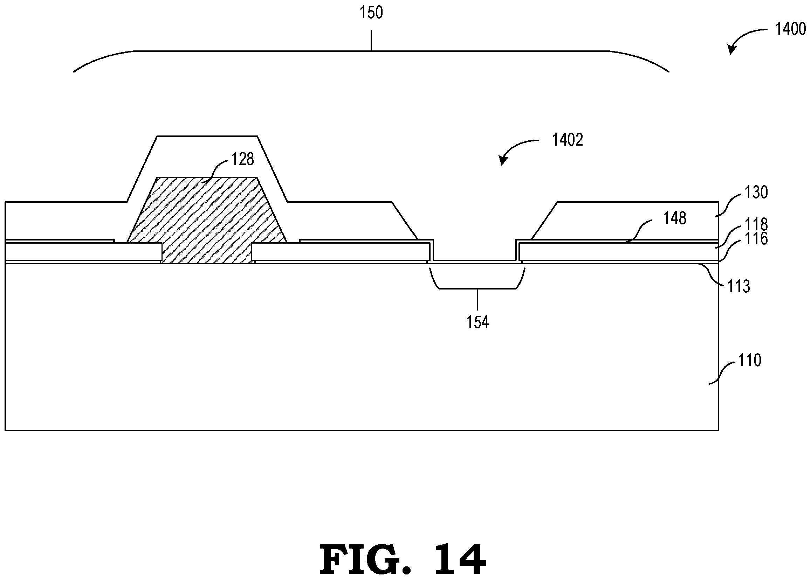

Referring next to step 224 of FIG. 2 and to FIG. 14, at a stage of fabrication 1400, a patterned dry etch is performed to form an opening 1402 in the ILD layer 130. For example, during the stage of fabrication 1400, an anisotropic dry etch process (e.g., a RIE process or other plasma etching process, as non-limiting examples) may be performed to remove portions of the ILD layer 130 to form the opening 1402. The opening 1402 may overlap the field plate channel 154. The third dielectric layer 148 may act as an etch stop for this dry etch process, thereby mitigating or preventing damage to the surface 113 of the substrate 110. This results in the exposed portions of the third dielectric layer 148 being damaged (e.g., due to plasma damage) by the dry etch process.

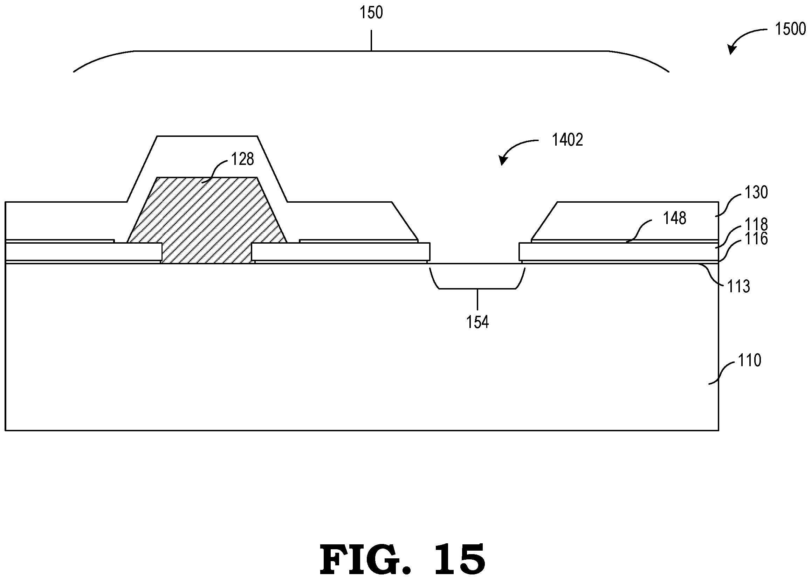

Referring next to step 226 of FIG. 2 and to FIG. 15, at a stage of fabrication 1500, a wet etch is performed to remove exposed portions of the third dielectric layer 148 (i.e., exposed through the opening 1402). For example, exposed portions of the third dielectric layer 148 that were damaged by the dry etch process at the step 1828 (those portions located in the field plate channel 154) are removed via this wet etch process. Some portions of the third dielectric layer 148 remain upon completion of this wet etch process, with such portions being disposed between upper surfaces of the second dielectric layer 118 and the ILD layer 130. Removal of these portions of the third dielectric layer 148 exposes the upper surface 113 of the substrate 110 (i.e., through the opening 1402).

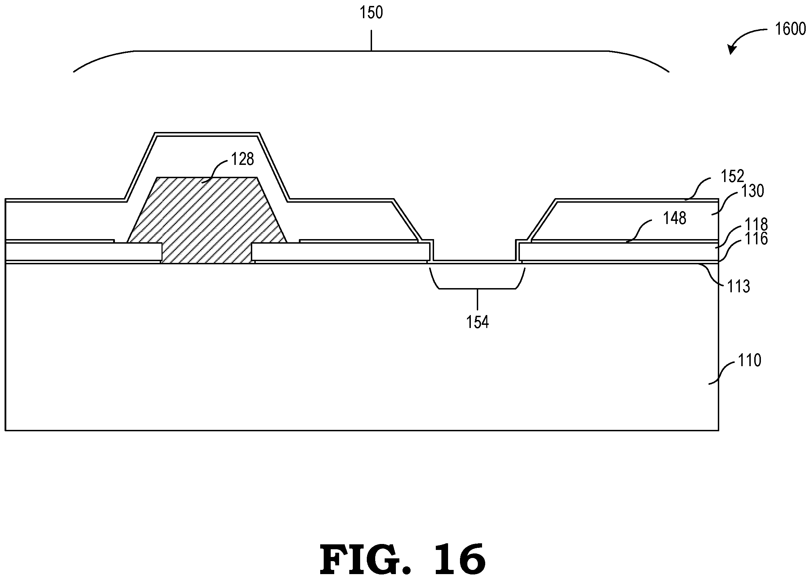

Referring next to step 228 of FIG. 2 and to FIG. 16, at a stage of fabrication 1600, a fourth dielectric layer 152 is formed over the substrate 110. The fourth dielectric layer 152 may be formed directly on surfaces of the ILD layer 130, on top and side surfaces of the second dielectric layer 118 in the field plate channel 154, on side surfaces of the first dielectric layer 116 in the field plate channel 154, and on the surface 113 of the substrate 110 in the field plate channel 154. In one or more embodiments, the fourth dielectric layer 152 may be formed from dielectric material, such as Al₂O₃, SiN, Si₃N₄, SiO₂, SiON, AlN, SiAlN, HfO₂, ZrO₂, TiO₂, or another suitable material, which may be deposited via PECVD or LPCVD as non-limiting examples. The fourth dielectric layer 152 may have a thickness range of around 30 Angstroms to around 5000 Angstroms.

Referring next to step 230 of FIG. 2 and to FIG. 17, at a stage of fabrication 1700, a field plate 135 is formed (e.g., deposited via sputtering, evaporation, or chemical vapor deposition as non-limiting examples, then patterned using a suitable photolithographic process) on the fourth dielectric layer 152. For example, a patterned conductive layer may be formed (e.g., deposited via sputtering, evaporation, or chemical vapor deposition as non-limiting examples, then patterned using a suitable photolithographic process) over the substrate 110 to form the field plate 135. For example, the conductive layer may include electrically conductive material, such as TiW, TiWN, WSi, or other suitable materials. The conductive layer may have a thickness in a range of about 100 Angstroms to about 5,000 Angstroms, although other suitable thicknesses may be used.

Separating the field plate 135 from the surface 113 of the substrate 110 using a dielectric layer that is formed after formation of the field plate channel 154 (i.e., the fourth dielectric layer 152) ensures that this dielectric material has not been damaged by the dry etch process used at the step 226 to extend the opening 1402 in the ILD layer 130 through the third dielectric layer 148, overlapping the field plate channel 154. Removal and replacement of damaged dielectric material in the field plate channel 154 reduces the likelihood of charge carrier traps being present in the field plate channel 154, which advantageously improves performance of the transistor device 100. This approach also provides better thickness uniformity of the dielectric material that separates the field plate 135 from the surface 113 in the field plate channel 154, which advantageously reduces process variation with respect to the amount of separation between the field plate 135 and the surface 113 in the field plate channel 154 and advantageously improves the stability of the gate threshold voltage of the transistor device 100.

It should be understood that additional processing steps may be performed to fabricate the transistor device 100, which may be performed before (e.g., ohmic implantation processes) or after performance of the method 200 of FIG. 2. Such processing steps may include the deposition and patterning of additional dielectric layers (e.g., dielectric layer 138 or other applicable dielectric layers) and metal layers (e.g., the interconnect layers 140, 141, or other applicable metal layers) as non-limiting examples.

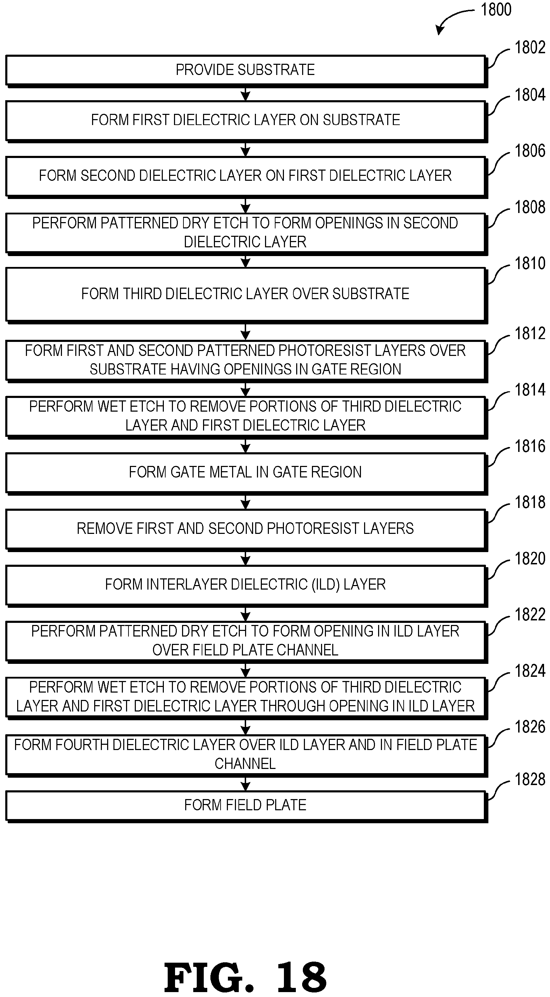

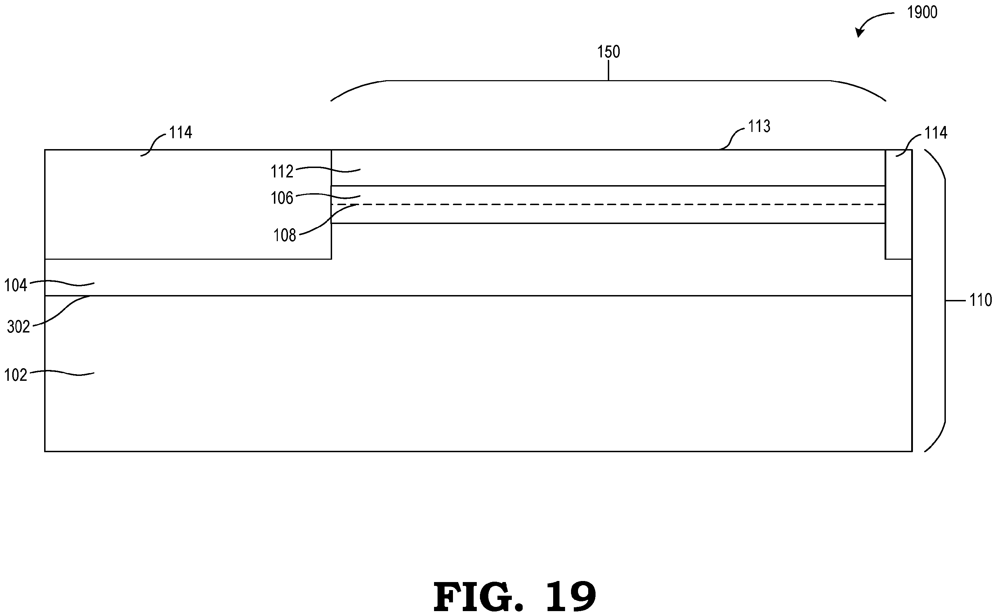

In one or more embodiments, it may be desirable to remove portions of the second and third dielectric layers in the gate channel and field plate channel concurrently, rather than separately, to reduce the number of times the surface 113 of the substrate 110 in these regions is exposed. Reduced exposure of the surface 113 may advantageously reduce the likelihood of the surface 113 being damaged during the fabrication process. Further, removing portions of the second and third dielectric layers concurrently, rather than in separate wet etch steps, may reduce the overall number of process steps required to fabricate the transistor device 100. For example, FIG. 18 is a process flow diagram depicting a method for fabricating at least a portion of a transistor device, such as the transistor device 100 of FIG. 1, in accordance with various embodiments, in which respective wet etch processes concurrently remove portions of the second and third dielectric layers from the gate channel and field plate channel. For enhanced understanding, FIG. 18 may be viewed simultaneously with FIGS. 19-32, which are cross sectional views depicting one or more embodiments of the transistor device 100 of FIG. 1 at various stages of fabrication.

Referring first to step 1802 of FIG. 18 and to FIG. 19, at a first stage of fabrication 1900, a semiconductor substrate 110 is provided, and an active region 150 is defined in the semiconductor substrate 110. It should be noted that various features of the step 1802 and the first stage of fabrication 1900 correspond to those described above in connection the step 202 of FIG. 2 and the stage of fabrication 300 of FIG. 3, with like reference numerals being used here to denote similar elements. Descriptions of such similar elements are not repeated here for sake of brevity.

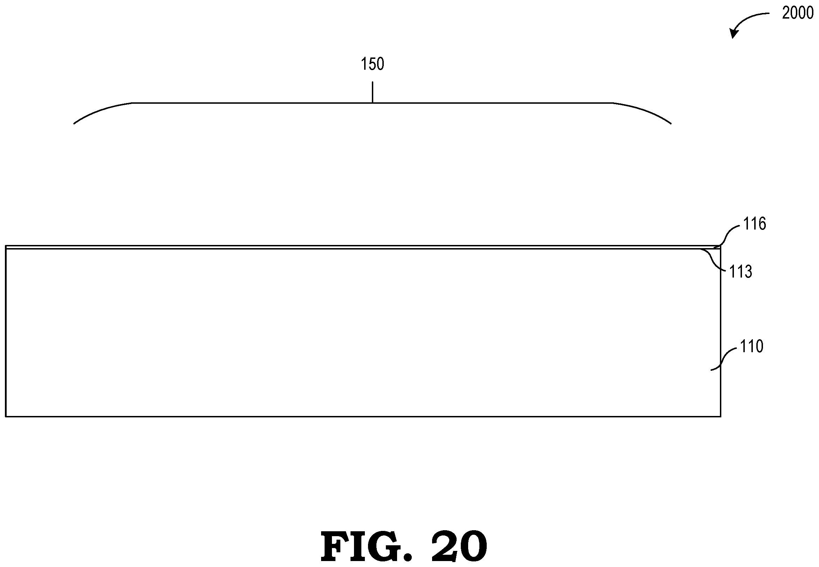

Referring next to step 1804 of FIG. 18 and to FIG. 20, during a stage of fabrication 2000, a first dielectric layer 116 is formed on (e.g., directly on and in contact with) the upper surface 113 of the semiconductor substrate 110. As mentioned above, in one or more embodiments, the first dielectric layer 116 may have a thickness in a range of about 30 Angstroms to about 1,500 Angstroms. The first dielectric layer 116 may be formed from dielectric material, such as Al₂O₃, SiN, Si₃N₄, SiO₂, SiON, AlN, SiAlN, HfO₂, ZrO₂, TiO₂, or another suitable material, which may be deposited via chemical vapor deposition (e.g., LPCVD) as a non-limiting example. In one or more embodiments, the first dielectric layer 116 may include an oxide (e.g., SiO₂, ZrO₂, HfO₂, Al₂O₃, or TiO₂ as non-limiting examples).

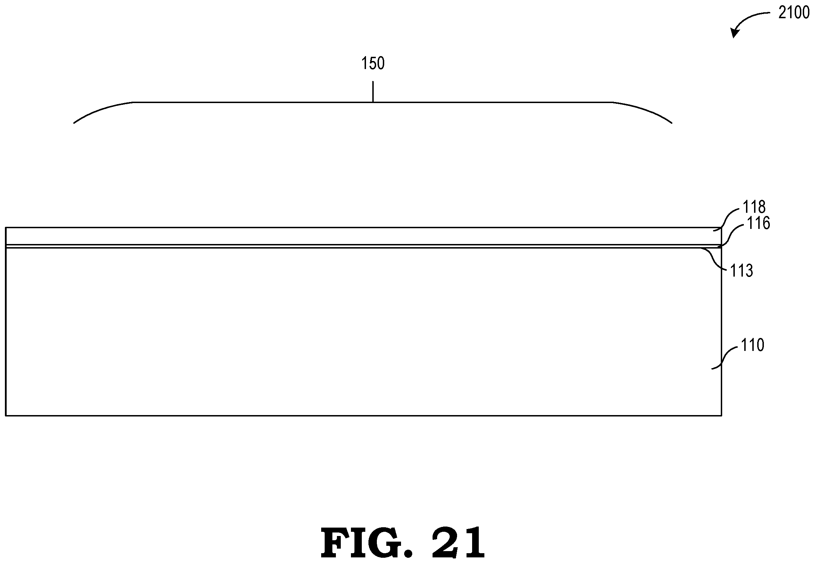

Referring next to step 1806 of FIG. 18 and to FIG. 21, during a stage of fabrication 2100, a second dielectric layer 118 is formed on (e.g., directly on and in contact with) the first dielectric layer 116. As mentioned above, in one or more embodiments, the second dielectric layer 118 may have a thickness in a range of about 100 Angstroms to about 4,000 Angstroms. The second dielectric layer 118 may be formed from dielectric material, such as Al₂O₃, SiN, Si₃N₄, SiO₂, SiON, AlN, SiAlN, HfO₂, ZrO₂, TiO₂, or another suitable material, which may be deposited via plasma enhanced chemical vapor deposition (e.g., PECVD) as a non-limiting example. In one or more embodiments, the second dielectric layer 118 may include a nitride (e.g., SiN, AlN, SiAlN as non-limiting examples).

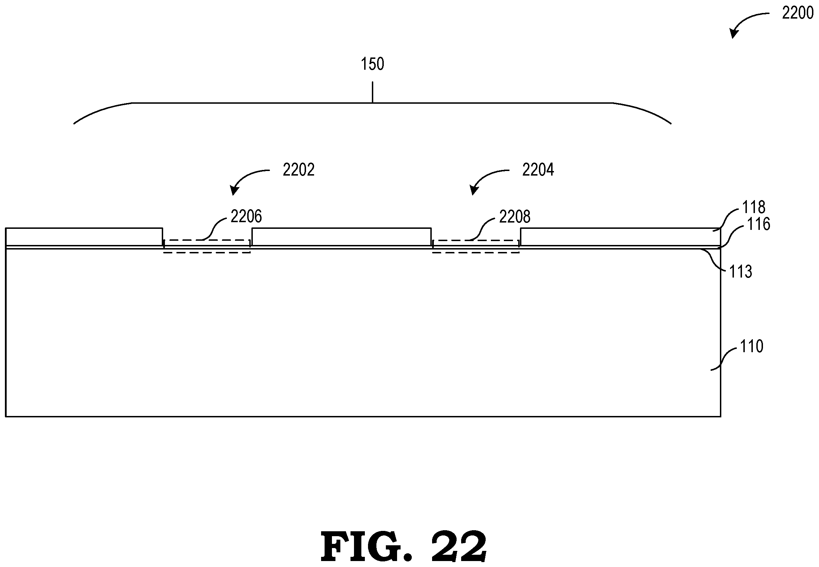

Referring next to step 1808 of FIG. 18 and to FIG. 22, during a stage of fabrication 2200, a patterned dry etch is performed to form an opening 2202 and an opening 2204 in the second dielectric layer 118. For example, during the stage of fabrication 2200, an dry etch process (e.g., a RIE process or other plasma etching process, as non-limiting examples) is performed in combination with a photolithographic process to remove portions of the second dielectric layer 118, forming the openings 2202, 2204 in the second dielectric layer 118, through which surfaces of the first dielectric layer 116 are exposed. The first dielectric layer 116 may act as an etch stop for this dry etch process, thereby mitigating or preventing damage to the surface 113 of the substrate 110. This results in exposed portions 2206, 2208 of the first dielectric layer 116 potentially being damaged (e.g., by exposure to plasma) by the dry etch process.

Additionally, some material of the exposed portion 2208 of the first dielectric layer 116 is removed during the dry etch process, and the amount of material removed in this way is process dependent and is likely not uniform across concurrently fabricated transistor devices (e.g., when processing a wafer that includes multiple transistor devices). This results in uncertainty as to the thickness of the exposed portion 2208 and reducing thickness uniformity of the exposed portion 2208.

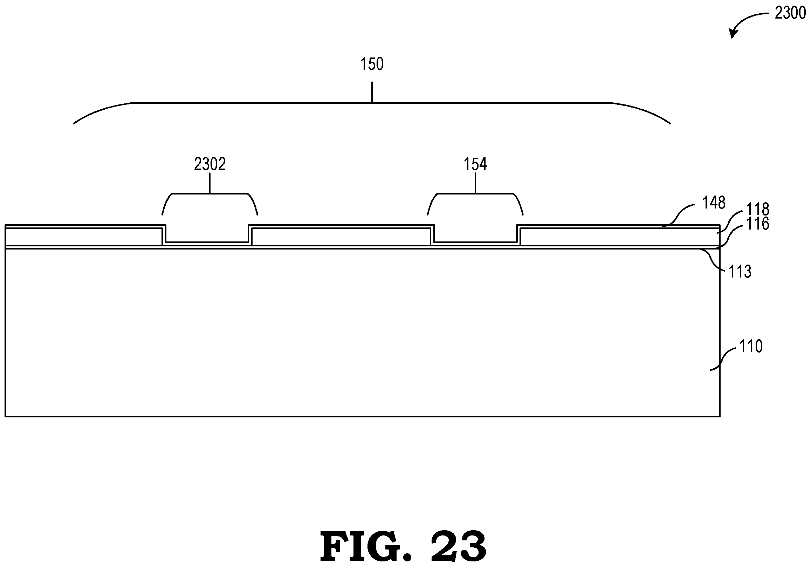

Referring next to step 1810 of FIG. 18 and to FIG. 23, during a stage of fabrication 2300, a third dielectric layer 148 is formed over the substrate 110. The third dielectric layer 148 may be formed directly on top and side surfaces of the second dielectric layer 118, and on upper surfaces of the first dielectric layer 116 in the gate channel 2302 and the field plate channel 154 (e.g., corresponding to surfaces of the damaged portions 2206, 2208 of the first dielectric layer 116). In one or more embodiments, the third dielectric layer 148 may be formed from dielectric material, such as Al₂O₃, SiN, Si₃N₄, SiO₂, SiON, AlN, SiAlN, HfO₂, ZrO₂, TiO₂, or another suitable material, which may be deposited via chemical vapor deposition (e.g., LPCVD) as a non-limiting example. In one or more embodiments, the third dielectric layer 148 may include an oxide (e.g., SiO₂, ZrO₂, HfO₂, Al₂O₃, or TiO₂ as non-limiting examples).

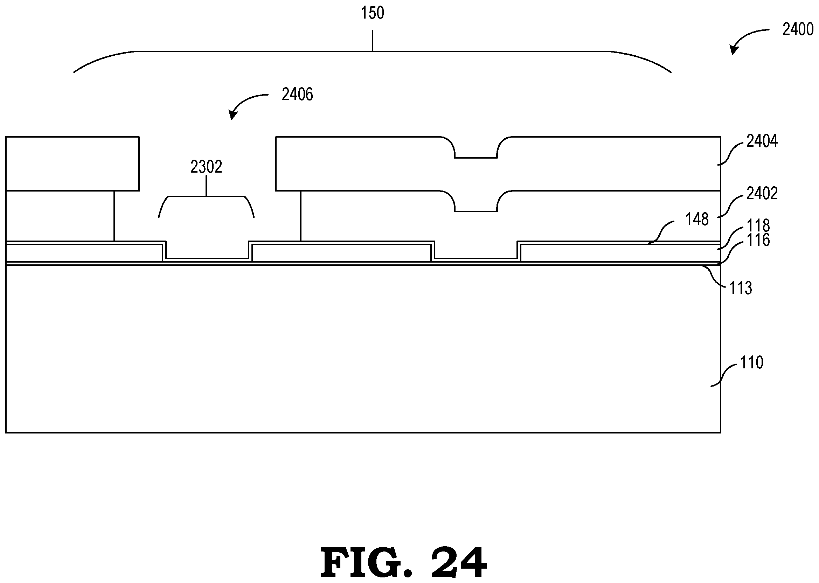

Referring next to step 1812 of FIG. 18 and to FIG. 24, during a stage of fabrication 2400, a first patterned photoresist layer 2402 and a second patterned photoresist layer 2404 are formed over the substrate 110. For example, the first patterned photoresist layer 2402 and the second patterned photoresist layer 2404 may be formed via respective photolithographic processes, each including spin coating photoresist material (e.g., resin) over the substrate 110, exposing the photoresist material to ultraviolet (UV) light through a patterned mask, and baking at a predetermined temperature, and removing portions of the photoresist material (e.g., removing those portions exposed to UV light when using positive photoresist material or removing those portions not exposed to UV light when using negative photoresist material) using a developer solution. An opening 2406 is formed through the first and second photoresist layers 902, 904 through which a region (i.e., the "gate channel region") including the gate channel 2302 is exposed.

In one or more embodiments, the first photoresist layer 2402 may be developed concurrently with the second photoresist layer 2404. As shown, the opening in the first photoresist layer 2402 may be wider than the opening in the second photoresist layer 2404, such that the second photoresist layer 2404 overhangs the first photoresist layer 2402 in the region of the opening 2406.

In an example embodiment, the first photoresist layer 2402 has a thickness of around 0.5 µm to around 2 µm, although it should be understood that other suitable thicknesses may be used. In an example embodiment, the second photoresist layer 2404 has a thickness of between around 0.25 µm to around 1.5 µm although other suitable thicknesses may be used.

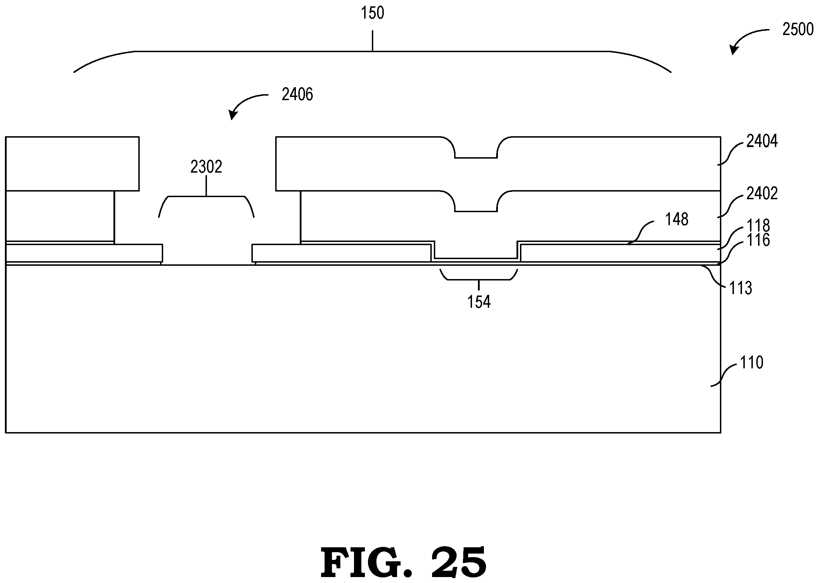

Referring next to step 1814 of FIG. 18 and to FIG. 25, during a stage of fabrication 2500, a wet etch is performed to remove exposed portions of the third dielectric layer 148 and portions of the first dielectric layer 116 (e.g., the damaged portion 2206) in the gate channel 2302. For example, portions of the third dielectric layer 148 exposed through the opening 2406 are removed via this wet etch process. Some portions of the third dielectric layer 148 remain upon completion of this wet etch process, which are disposed beneath the photoresist layer 2402. By removing the portions of the third dielectric layer 148 and the first dielectric layer 116 in the gate channel 2302 concurrently in this way, exposure of the surface 113 of the substrate 110 in the gate channel 2302 after formation of the first dielectric layer 116 and prior to formation of the third dielectric layer 148 is advantageously avoided, and the number of process steps performed is advantageously reduced.

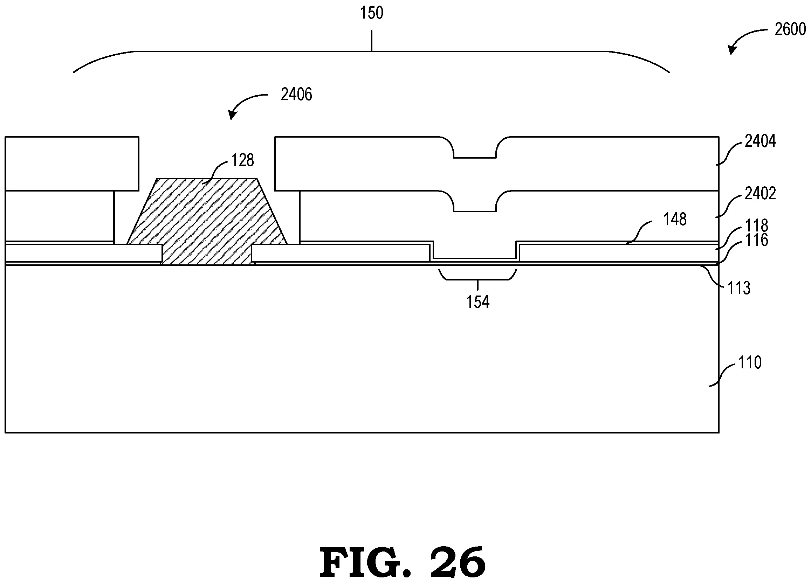

Referring next to step 1816 of FIG. 18 and to FIG. 26, during a stage of fabrication 2600, a gate structure 128 is formed through the opening 2406 that extends through the first photoresist layer 2402 and the second photoresist layer 2404. The gate structure 128 may be electromagnetically coupled to the channel 108 through the upper surface 113 of the substrate 110 and the barrier layer 112. During operation of the transistor device 100, changes to the electric potential of gate structure 128 may shift the quasi-Fermi level for the barrier layer 112 compared to the quasi-Fermi level for the channel layer 106 and thereby modulate the electron concentration in the channel 108 within the portion of the substrate 110 under the gate structure 128. One or more aspects of the gate structure 128 in the stage of fabrication 2600 may be similar to those of the gate structure 128 in the stage of fabrication 1100 of FIG. 11, as described above, and such aspects are not repeated here for sake of brevity.

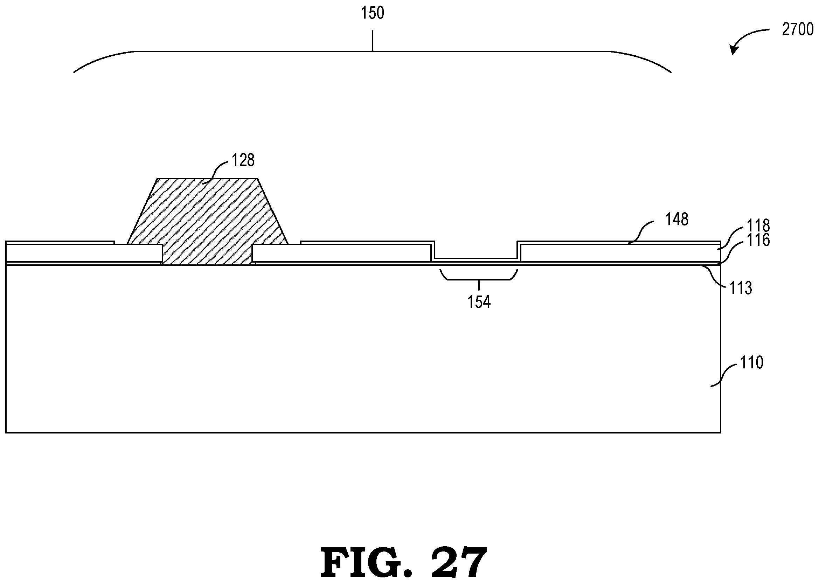

Referring next to step 1818 of FIG. 18 and to FIG. 27, during a stage of fabrication 2700, the first photoresist layer 2402, the second photoresist layer 2404, and the second portion of gate metal deposited on the surface(s) of the second photoresist layer 2404 are concurrently removed via a lift-off process. For example, in the lift-off process, a photoresist striper (e.g., a solvent such as acetone, 1-methyl-2-pyrrolidone, or dimethyl sulfoxide) may be applied to remove the first photoresist layer 2402 and the second photoresist layer 2404, which detaches (i.e., "lifts-off") the excess gate metal on the surface of the second photoresist layer 2404.

While a bi-layer lift-off process has been described in connection with steps 1812, 1814, 1816, 1818 of FIG. 18 and stages of fabrication 2400, 2500, 2600, 2700 of FIGS. 24-27, it should be understood that this is intended to be illustrative and not limiting. For example, other photolithographic processes (e.g., using a single photoresist layer that is developed with an undercut profile) may instead be used when forming the gate structure 128 in one or more other embodiments.

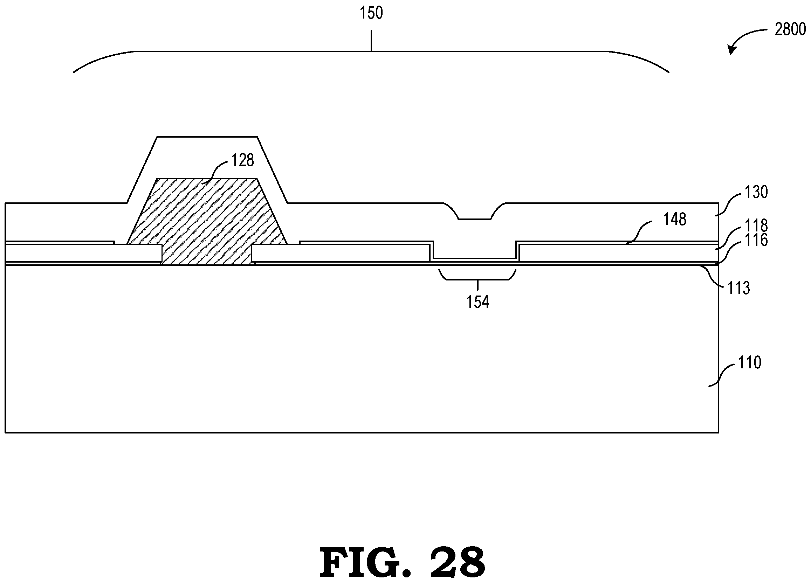

Referring next to step 1820 of FIG. 18 and to FIG. 28, during a stage of fabrication 2800, an ILD layer 130 is formed over the substrate 110 (e.g., in contact with surfaces of each of the second dielectric layer 118 and the gate structure 128). In one or more embodiments, the ILD layer 130 has a thickness in a range of about 500 Angstroms to about 10,000 Angstroms, although other suitable thicknesses may be used. The ILD layer 130 may be formed from silicon nitride, silicon oxide, silicon oxynitride or other suitable dielectric materials, as non-limiting examples.

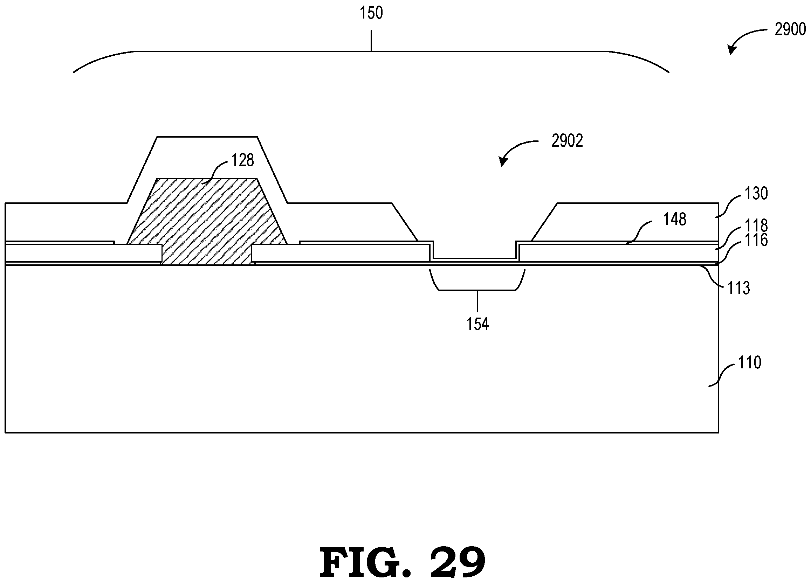

Referring next to step 1822 of FIG. 18 and to FIG. 29, at a stage of fabrication 2900, a patterned dry etch is performed to form an opening 2902 in the ILD layer 130. For example, during the stage of fabrication 2900, a dry etch process (e.g., a RIE process or other plasma etching process, as non-limiting examples) may be performed to remove portions of the ILD layer 130 to form the opening 2902. The opening 2902 may overlap the field plate channel 154. The third dielectric layer 148 may act as an etch stop for this dry etch process, thereby mitigating or preventing damage to the surface 113 of the substrate 110. This results in the exposed portions of the third dielectric layer 148 being damaged (e.g., due to plasma damage) by the dry etch process.

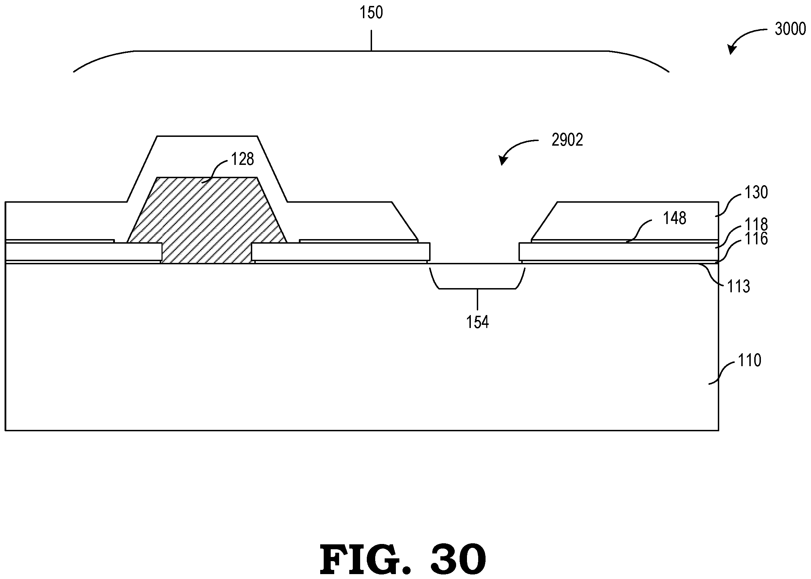

Referring next to step 1824 of FIG. 18 and to FIG. 30, at a stage of fabrication 3000, a wet etch is performed to remove exposed portions of the third dielectric layer 148 (i.e., exposed through the opening 2902) and portions of the first dielectric layer 116 (e.g., the damaged portion 2208) in the field plate channel 154, thereby exposing the surface 113 of the substrate 110 in the field plate channel 154. For example, exposed portions of the third dielectric layer 148 that were damaged by the dry etch process at the step 1822 (those portions located in the field plate channel 154) are removed via this wet etch process. Some portions of the third dielectric layer 148 remain upon completion of this wet etch process, with such portions being disposed between upper surfaces of the second dielectric layer 118 and the ILD layer 130. By removing the portions of the third dielectric layer 148 and the first dielectric layer 116 in the field plate channel 154 concurrently in this way, exposure of the surface 113 of the substrate 110 in the field plate channel 154 after formation of the first dielectric layer 116 and prior to formation of the third dielectric layer 148 is advantageously avoided, and the number of process steps performed is advantageously reduced.

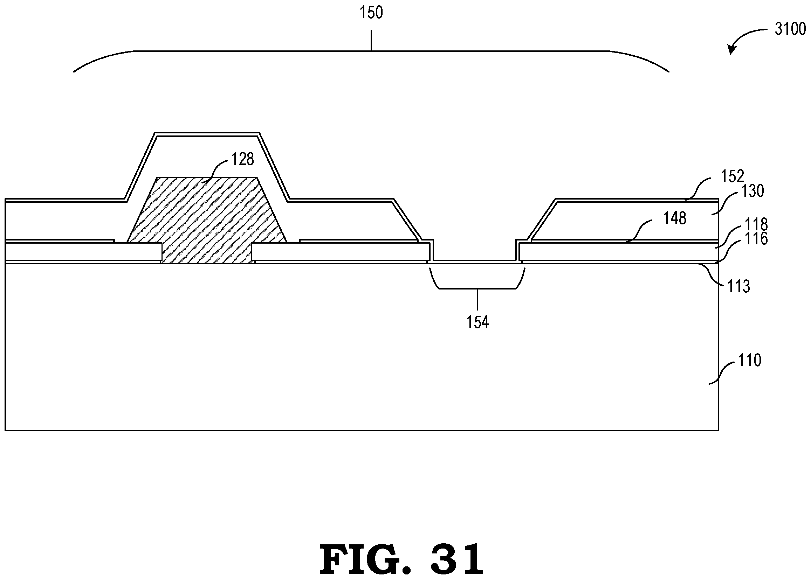

Referring next to step 1826 of FIG. 18 and to FIG. 31, at the stage of fabrication 3100, a fourth dielectric layer 152 is formed over the substrate 110. The fourth dielectric layer 152 may be formed directly on surfaces of the ILD layer 130, on top and side surfaces of the second dielectric layer 118 in the field plate channel 154, on side surfaces of the first dielectric layer 116 in the field plate channel 154, and on the surface 113 of the substrate 110 in the field plate channel 154. In one or more embodiments, the fourth dielectric layer 152 may be formed from dielectric material, such as Al₂O₃, SiN, Si₃N₄, SiO₂, SiON, AlN, SiAlN, HfO₂, ZrO₂, TiO₂, or another suitable material, which may be deposited via PECVD or LPCVD as non-limiting examples. The fourth dielectric layer 152 may have a thickness range of around 30 Angstroms to around 5000 Angstroms.

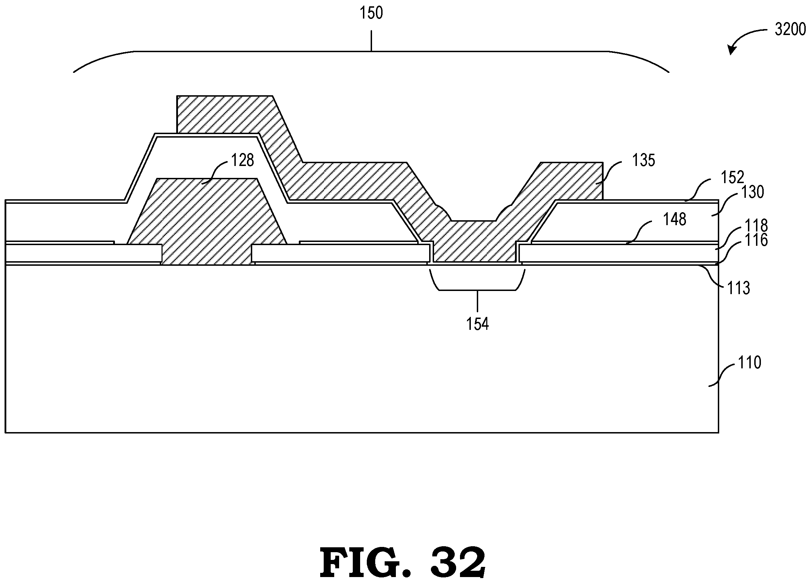

Referring next to step 1828 of FIG. 18 and to FIG. 32, at a stage of fabrication 3200, a field plate 135 is formed on the fourth dielectric layer 152. For example, a patterned conductive layer may be formed (e.g., deposited via sputtering, evaporation, or chemical vapor deposition as non-limiting examples, then patterned using a suitable photolithographic process) over the substrate 110 to form the field plate 135. For example, the conductive layer may include electrically conductive material, such as TiW, TiWN, WSi, or other suitable materials. The conductive layer may have a thickness in a range of about 100 Angstroms to about 5,000 Angstroms, although other suitable thicknesses may be used.

Separating the field plate 135 from the surface 113 of the substrate 110 using a dielectric layer that is formed after formation of the field plate channel 154 (i.e., the fourth dielectric layer 152) ensures that this dielectric material has not been damaged by the dry etch process used at the step 1824 to extend the opening 2902 in the ILD layer 130 through the third dielectric layer 148, overlapping the field plate channel 154. Removal and replacement of damaged dielectric material in the field plate channel 154 reduces the likelihood of charge carrier traps being present in the field plate channel 154, which advantageously improves performance of the transistor device 100. This approach also provides better thickness uniformity of the dielectric material that separates the field plate 135 from the surface 113 in the field plate channel 154, which advantageously reduces process variation with respect to the amount of separation between the field plate 135 and the surface 113 in the field plate channel 154 and advantageously improves the stability of the gate threshold voltage of the transistor device 100.

It should be understood that additional processing steps may be performed to fabricate the transistor device 100, which may be performed before (e.g., ohmic implantation processes) or after performance of the method 1800 of FIG. 18. Such processing steps may include the deposition and patterning of additional dielectric layers (e.g., dielectric layer 138 or other applicable dielectric layers) and metal layers (e.g., the interconnect layers 140, 141, or other applicable metal layers), as non-limiting examples.

The foregoing description refers to elements or nodes or features being "connected" or "coupled" together. As used herein, unless expressly stated otherwise, "connected" means that one element is directly j oined to (or directly communicates with) another element, and not necessarily mechanically. Likewise, unless expressly stated otherwise, "coupled" means that one element is directly or indirectly joined to (or directly or indirectly communicates with) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims.

## Claims

1. A transistor device comprising:
a semiconductor substrate;
a first dielectric layer disposed on a surface of the semiconductor substrate;
a second dielectric layer disposed directly on the first dielectric layer;
a third dielectric layer disposed on portions of the second dielectric layer, wherein a gate channel is at least partially defined via a first opening that extends through the first dielectric layer, the second dielectric layer, and the third dielectric layer;
a gate structure disposed directly on the surface of the semiconductor substrate in the gate channel, wherein portions of the first dielectric layer and the second dielectric layer are interposed directly between portions of the gate structure and the surface of the semiconductor substrate; and
a field plate disposed at least partially overlapping the gate structure, wherein a portion of the field plate is disposed in a field plate channel that is at least partially defined via a second opening that extends through at least the second dielectric layer and the third dielectric layer.

2. The transistor device of claim 1, further comprising an interlayer dielectric layer disposed over the first dielectric layer, the second dielectric layer, the third dielectric layer, and the gate structure.

3. The transistor device of claim 2, wherein the field plate at least partially overlaps the interlayer dielectric layer, such that the interlayer dielectric layer is interposed between the gate structure and the field plate.

4. The transistor device of claim 3, further comprising a fourth dielectric layer that is at least partially disposed directly on the surface of the semiconductor substrate in the field plate channel.

5. The transistor device of claim 4, wherein portions of the fourth dielectric layer are disposed directly on surfaces of the interlayer dielectric layer, the first dielectric layer, the second dielectric layer, and the third dielectric layer.

6. The transistor device of claim 5, wherein the field plate is disposed directly on the fourth dielectric layer.

7. The transistor device of claim 6, wherein the fourth dielectric layer separates the field plate from the surface of the semiconductor substrate in the field plate channel.

8. The transistor device of any of claims 4 to 7, wherein the first dielectric layer and the third dielectric layer each include first dielectric material, the second dielectric layer and the interlayer dielectric layer each include second dielectric material, and the second dielectric material has as a different etch rate from the first dielectric material with respect to at least one wet etch process.

9. A method of fabricating a transistor device, the method comprising:
providing a semiconductor substrate;
forming a first dielectric layer on the semiconductor substrate;
forming a second dielectric layer on the first dielectric layer;
forming a gate channel and a field plate channel by:
performing a first patterned dry etch to form a first opening and a second opening in the second dielectric layer; and
performing a first wet etch to form a third opening and a fourth opening in the first dielectric layer;
forming a third dielectric layer directly on the second dielectric layer and directly on surfaces of the semiconductor substrate exposed through the third opening and the fourth opening;
removing a first portion of the third dielectric layer from the gate channel;
forming a gate structure disposed at least partially in the gate channel and in contact with surfaces of the semiconductor substrate, the first dielectric layer, and the second dielectric layer; and
forming a field plate overlapping the gate structure, wherein at least a portion of the field plate is disposed in the field plate channel.

10. The method of claim 9, further comprising:
forming a first patterned photoresist layer over the semiconductor substrate having a fifth opening overlapping the gate channel; and
forming a second patterned photoresist layer over the semiconductor substrate having a sixth opening overlapping the gate channel, wherein removing the first portion of the third dielectric layer from the gate channel comprises:
after forming the first patterned photoresist layer and the second patterned photoresist layer, performing a second wet etch to remove the first portion of the third dielectric layer.

11. The method of claim 9 or 10, further comprising:
forming an interlayer dielectric layer on the gate structure and the third dielectric layer, wherein the field plate is disposed over the interlayer dielectric layer.

12. The method of claim 11, further comprising:
performing a second patterned dry etch to form a seventh opening in the interlayer dielectric layer through which a portion of the third dielectric layer is exposed.

13. The method of claim 12, further comprising:
before forming the field plate, performing a second wet etch to remove a second portion of the third dielectric layer that is exposed through the seventh opening; and
before forming the field plate, forming a fourth dielectric layer disposed on surfaces of the interlayer dielectric layer and, in the field plate channel, on the surface of the semiconductor substrate.

14. The method of claim 13, wherein the field plate is formed in direct contact with the fourth dielectric layer, and the fourth dielectric layer is directly interposed between the field plate and the surface of the semiconductor substrate in the field plate channel.
